(19) **Europäisches Patentamt / European Patent Office / Office européen des brevets**

(11) **EP 4 761 094 A1**

(12) **EUROPEAN PATENT APPLICATION**
published in accordance with Art. 153(4) EPC

(43) Date of publication:
**17.06.2026 Bulletin 2026/25**

(21) Application number: **24866883.2**

(22) Date of filing: **16.05.2024**

(51) International Patent Classification (IPC):
**H02M 7/5387** (2007.01)   **G01R 19/25** (2006.01)
**G01R 15/20** (2006.01)   **H02M 7/5395** (2006.01)
**H02M 1/00** (2006.01)   **H02M 7/48** (2007.01)
**H02M 7/539** (2006.01)   **H02J 3/40** (2026.01)

(52) Cooperative Patent Classification (CPC):
**H02M 7/539; G01R 15/20; G01R 19/25; H02J 3/40; H02M 1/0009; H02M 7/4807; H02M 7/5387; Y02E 10/56**

(86) International application number:
**PCT/CN2024/093546**

(87) International publication number:
**WO 2025/060459 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.09.2023 CN 202311235636**

(71) Applicant: **Huawei Digital Power Technologies Co., Ltd.**
**Shenzhen, Guangdong 518043 (CN)**

(72) Inventors:
• **ZHANG, Chengliang**
  **Shenzhen, Guangdong 518043 (CN)**
• **HU, Yaowei**
  **Shenzhen, Guangdong 518043 (CN)**
• **LI, Jianshan**
  **Shenzhen, Guangdong 518043 (CN)**
• **MA, Xinyi**
  **Shenzhen, Guangdong 518043 (CN)**

(74) Representative: **Maiwald GmbH**
**Engineering**
**Elisenhof**
**Elisenstrasse 3**
**80335 München (DE)**

(54) **MICRO INVERTER AND CURRENT MEASUREMENT METHOD**

(57) This application provides a microinverter and a current detection method. The microinverter includes: a primary-side circuit, configured to connect to a photovoltaic module, and convert a direct current output by the photovoltaic module into an alternating current; a transformer, where a primary-side winding of the transformer is coupled to the primary-side circuit, and the transformer is configured to boost or buck the alternating current obtained through conversion of the primary-side circuit; a secondary-side circuit, where a secondary-side winding of the transformer is coupled to the secondary-side circuit, and the secondary-side circuit is configured to convert an alternating current obtained through boosting and bucking into a power frequency alternating current, and is configured to output the power frequency alternating current to a power grid through an output port; and a current detection circuit, including a current transformer. The current transformer is located between the secondary-side winding of the transformer and the secondary-side circuit. The current detection circuit is configured to: collect a high-frequency alternating current of the secondary-side winding via the current transformer, and detect, based on the high-frequency alternating current, the alternating current output by the output port. A component in the alternating current detection circuit in this application has a small volume and low costs, and is suitable for use in the microinverter.

FIG. 4

## Description

This application claims priority to Chinese Patent Application No. 202311235636.X, filed with the China National Intellectual Property Administration on September 21, 2023 and entitled "MICROINVERTER AND CURRENT DETECTION METHOD", which is incorporated herein by reference in its entirety.

## TECHNICAL FIELD

This application relates to the field of power technologies, and in particular, to a microinverter and a current detection method.

## BACKGROUND

A microinverter can directly convert a direct current of a photovoltaic module into an alternating current, and is widely used in a photovoltaic power generation system in a residential scenario at present. Currently, detection of an alternating current side current mainly focuses on disposing a sampling component at an alternating current grid connection port. For example, a power frequency current transformer and a back-end conversion circuit are added to the alternating current grid connection port, to detect a grid-connected alternating current. However, the power frequency current transformer has a large size, is inconvenient to mount, is not applicable to a microinverter scenario, and has high costs.

## SUMMARY

This application provides a microinverter and a current detection method. An alternating current detection circuit in the microinverter is disposed between a secondary-side winding of a transformer and a secondary-side circuit, and the alternating current detection circuit detects a high-frequency current of the secondary-side winding of the transformer. A higher current frequency indicates a smaller volume of a coil. Therefore, a current transformer in the alternating current detection circuit in this application has a small volume and low costs, and is suitable for use in the microinverter.

According to a first aspect, a microinverter is provided, including: a primary-side circuit, where the primary-side circuit is configured to connect to a photovoltaic module, and convert a direct current output by the photovoltaic module into an alternating current; a transformer, where a primary-side winding of the transformer is coupled to the primary-side circuit, and the transformer is configured to boost or buck the alternating current obtained through conversion of the primary-side circuit; a secondary-side circuit, where a secondary-side winding of the transformer is coupled to the secondary-side circuit, and the secondary-side circuit is configured to convert an alternating current obtained through boosting and bucking into a power frequency alternating current, and is configured to output the power frequency alternating current to a power grid through an output port; and a current detection circuit, where the current detection circuit includes a current transformer, the current transformer is located between the secondary-side winding of the transformer and the secondary-side circuit, and the current detection circuit is configured to: collect a high-frequency alternating current of the secondary-side winding via the current transformer, and detect, based on the high-frequency alternating current, the alternating current output by the output port. A frequency of the high-frequency alternating current is greater than a frequency of the power frequency alternating current.

In this embodiment of this application, the current detection circuit is configured to: detect the high-frequency current of the secondary-side winding of the transformer, and detect the alternating current at the port of the power grid based on the high-frequency current of the secondary-side winding of the transformer. In this way, the alternating current at the port of the power grid is not directly collected, but the alternating current at the port of the power grid is indirectly obtained based on the high-frequency current of the secondary-side winding of the transformer. The alternating current detection circuit detects the high-frequency current of the secondary-side winding of the transformer, and a higher frequency indicates a smaller volume of a coil. Therefore, a component in the alternating current detection circuit in this embodiment of this application has a small volume and low costs, and is suitable for use in the microinverter. In addition, because the current detection circuit is located between the secondary-side winding of the transformer and the secondary-side circuit, a response speed and efficiency of identifying a fault that occurs in the transformer or the primary-side circuit are higher, and the inverter can be better protected.

With reference to the first aspect, in a first possible implementation, the microinverter further includes a controller, and the current detection circuit further includes a sampling circuit, a switch circuit, and an integration filter circuit. A primary side of the current transformer is connected between the secondary-side winding of the transformer and the secondary-side circuit, and a secondary side of the current transformer is connected to the sampling circuit. The sampling circuit is connected to the integration filter circuit via the switch circuit, and the switch circuit includes a switching transistor. The controller is configured to control the switching transistor in the switch circuit to be turned on or off, so that the integration filter circuit restores an output voltage of the sampling circuit. A current, a voltage, or a frequency of an alternating current obtained through restoration of the integration filter circuit is consistent with that of the alternating current output by the output port.

In this embodiment of this application, the controller controls the switching transistor in the switch circuit to be turned on or off, so that the integration filter circuit restores the output voltage of the sampling circuit. The alternating current obtained through restoration of the integration filter circuit is a consecutive alternating current at the port of the power grid, and parameters of the obtained alternating current at the port are more comprehensive and accurate, so that the alternating current output by the microinverter can be connected to the power grid. Therefore, safety of the power grid can be ensured.

With reference to the first possible implementation of the first aspect, in a second possible implementation, the sampling circuit includes two sampling resistors and a sampling capacitor. The two sampling resistors are connected in series and then connected to two ends of the secondary side of the current transformer, one end of the sampling capacitor is connected to a connection midpoint of the two sampling resistors, and the other end is grounded.

With reference to the first possible implementation and the second possible implementation of the first aspect, in a third possible implementation, the secondary-side circuit includes a bridge arm and two capacitors. The two capacitors are connected in series and then connected in parallel to the bridge arm, and the bridge arm includes an upper half bridge arm and a lower half bridge arm. A connection point between the upper half bridge arm and the lower half bridge arm is connected to one end of the secondary-side winding of the transformer, and a connection point between the two capacitors is connected to the other end of the secondary-side winding of the transformer. Each of the upper half bridge arm and the lower half bridge arm includes one group of switching transistors. Two switching transistors included in each group of switching transistors each include a freewheeling diode connected in parallel, and freewheeling directions of the two freewheeling diodes connected in parallel to each group of switching transistors are opposite. The switch circuit includes two groups of controllable switches. That the controller is configured to control the switching transistor in the switch circuit to be turned on or off, so that the integration filter circuit restores an output voltage of the sampling circuit includes: The controller is configured to control, based on statuses of the four switching transistors included in the bridge arm and a current direction of the secondary-side winding of the transformer, the two groups of controllable switches to be turned on or off, so that the integration filter circuit restores the output voltage of the sampling circuit.

In this embodiment of this application, the controller controls, based on the statuses of the four switching transistors included in the bridge arm and the current direction of the secondary-side winding of the transformer, the two groups of controllable switches to be turned on or off, so that the integration filter circuit restores the output voltage of the sampling circuit. In addition, a polarity of the voltage output by the integration filter circuit is consistent with a polarity of a voltage output by the secondary-side circuit, to ensure that the voltage output by the integration filter circuit is the alternating current at the port of the power grid. Therefore, it is more reliable to obtain the alternating current at the port of the power grid based on the voltage output by the integration filter circuit. Further, this helps the microinverter invert the direct current output by the photovoltaic module into the alternating current and then connect the alternating current to the power grid, thereby ensuring safety of the power grid.

With reference to the third possible implementation of the first aspect, in a fourth possible implementation, that the controller is configured to control, based on statuses of the four switching transistors included in the bridge arm and a current direction of the secondary-side winding of the transformer, the two groups of controllable switches to be turned on or off includes: When the two switching transistors included in the upper half bridge arm are turned on or the two switching transistors included in the lower half bridge arm are turned on, or when only one of the four switching transistors is turned on, the controller is configured to control, based on the current direction of the secondary-side winding of the transformer and a polarity of a voltage of an output end of the secondary-side circuit, one group of controllable switches in the two groups of controllable switches to be turned on and the other group of controllable switches to be turned off.

In this embodiment of this application, when the two switching transistors included in the upper half bridge arm are turned on or the two switching transistors included in the lower half bridge arm are turned on, or when only one of the four switching transistors is turned on, the controller is configured to control, based on the current direction of the secondary-side winding of the transformer and the polarity of the voltage of the output end of the secondary-side circuit, one group of controllable switches in the two groups of controllable switches to be turned on and the other group of controllable switches to be turned off, to ensure that the voltage output by the integration filter circuit is the alternating current at the port of the power grid. Therefore, it is more reliable to obtain the alternating current at the port of the power grid based on the voltage output by the integration filter circuit. Further, this helps the microinverter invert the direct current output by the photovoltaic module into the alternating current and then connect the alternating current to the power grid, thereby ensuring safety of the power grid.

With reference to the third possible implementation of the first aspect, in a fifth possible implementation, that the controller is configured to control, based on statuses of the four switching transistors included in the bridge arm and a current direction of the secondary-side winding of the transformer, the two groups of controllable switches to be turned on or off includes: When one switching transistor in the upper half bridge arm and one switching transistor in the lower half bridge arm are turned on, when the two switching transistors in the upper half bridge arm and one switching transistor in the lower half bridge arm are turned on, or when one switching transistor in the upper half bridge arm and the two switching transistors in the lower half bridge arm are turned on, the controller is configured to control, based on the current direction of the secondary-side winding of the transformer, the two groups of controllable switches to be alternately turned on or off.

In this embodiment of this application, when at least one switching transistor in the upper half bridge arm is turned on and at least one switching transistor in the lower half bridge arm is turned on, current directions of the secondary-side winding of the transformer may be the same but polarities of voltages of the output end of the secondary-side circuit may be different, or current directions of the secondary-side winding of the transformer may be different but the polarities of the voltages of the output end of the secondary-side circuit may be the same. Therefore, the controller controls, based on specific on/off statuses of the switching transistors and the current direction of the secondary-side winding of the transformer, the two groups of controllable switches to be alternately turned on or off, to ensure that the voltage output by the integration filter circuit is the alternating current at the port of the power grid. Therefore, it is more reliable to obtain the alternating current at the port of the power grid based on the voltage output by the integration filter circuit. Further, this helps the microinverter invert the direct current output by the photovoltaic module into the alternating current and then connect the alternating current to the power grid, thereby ensuring safety of the power grid.

With reference to the fifth possible implementation of the first aspect, in a sixth possible implementation, the upper half bridge arm includes a switching transistor S8 and a switching transistor S6, and the lower half bridge arm includes a switching transistor S5 and a switching transistor S7. That the controller is configured to control, based on the current direction of the secondary-side winding of the transformer, the two groups of controllable switches to be alternately turned on or off includes: When the switching transistor S6 is turned on, the current direction of the secondary-side winding of the transformer is positive, and the controller controls, based on the positive current direction of the secondary-side winding of the transformer, one group of controllable switches to be turned on; or when the switching transistor S8 is turned on, the current direction of the secondary-side winding of the transformer is negative, and the controller controls, based on the negative current direction of the secondary-side winding of the transformer, one group of controllable switches to be turned on; or when the switching transistor S5 is turned on, the current direction of the secondary-side winding of the transformer is positive, and the controller controls, based on the positive current direction of the secondary-side winding of the transformer, the other group of controllable switches to be turned on; or when the switching transistor S7 is turned on, the current direction of the secondary-side winding of the transformer is negative, and the controller controls, based on the negative current direction of the secondary-side winding of the transformer, the other group of controllable switches to be turned on.

In this embodiment of this application, the controller controls, based on specific on/off statuses of the switching transistors and the current direction of the secondary-side winding of the transformer, the two groups of controllable switches to be alternately turned on, to ensure that the voltage output by the integration filter circuit is the alternating current at the port of the power grid. Therefore, it is more reliable to obtain the alternating current at the port of the power grid based on the voltage output by the integration filter circuit. Further, this helps the microinverter invert the direct current output by the photovoltaic module into the alternating current and then connect the alternating current to the power grid, thereby ensuring safety of the power grid.

With reference to the sixth possible implementation of the first aspect, in a seventh possible implementation, one group of controllable switches is connected between one end of the two sampling resistors connected in series and an inverting input end of the integration filter circuit, and the one end of the two sampling resistors connected in series is connected to a non-dotted terminal of the secondary-side winding of the transformer. The other group of controllable switches is connected between the other end of the two sampling resistors connected in series and the inverting input end of the integration filter circuit, the one end of the two sampling resistors connected in series is connected to a dotted terminal of the secondary-side winding of the transformer, and the connection midpoint of the two sampling resistors is connected to a non-inverting input end of the integration filter circuit.

With reference to any one of the third possible implementation to the seventh possible implementation of the first aspect, in an eighth possible implementation, each group of controllable switches includes two switching transistors and one freewheeling resistor. Sources of the two switching transistors in each group of controllable switches are connected. Drains of two switching transistors in one group of controllable switches are respectively connected to one end of the two sampling resistors connected in series and the inverting input end of the integration filter circuit. Drains of two switching transistors in the other group of controllable switches are respectively connected to the other end of the two sampling resistors connected in series and the inverting input end of the integration filter circuit. Each of the two switching transistors in each group of controllable switches includes a freewheeling diode connected in parallel, and freewheeling directions of the two freewheeling diodes connected in parallel to each group of controllable switches are opposite. Two ends of the freewheeling resistor are connected in parallel to the drains of the two switching transistors. Alternatively, drains of the two switching transistors in each group of controllable switches are connected. Sources of two switching transistors in one group of controllable switches are respectively connected to one end of the two sampling resistors connected in series and the inverting input end of the integration filter circuit. Sources of two switching transistors in the other group of controllable switches are respectively connected to the other end of the two sampling resistors connected in series and the inverting input end of the integration filter circuit. Each of the two switching transistors in each group of controllable switches includes a freewheeling diode connected in parallel, and freewheeling directions of the two freewheeling diodes connected in parallel to each group of controllable switches are opposite. Two ends of the freewheeling resistor are connected in parallel to the sources of the two switching transistors. Gates of the two switching transistors in each group of controllable switches are connected, and the controller is configured to control a high level or a low level to be input to the gates of the switching transistors, to control the two groups of controllable switches to be turned on or off.

In this embodiment of this application, each group of controllable switches includes two switching transistors, each of the two switching transistors is connected in parallel to a freewheeling diode, and freewheeling directions of the two diodes are opposite. When the four switching transistors in the secondary-side circuit are in a dead zone, the two switching transistors whose freewheeling directions are opposite can prevent a current of the integration filter circuit from being reversely input to the secondary-side circuit through the current transformer, thereby avoiding damage to the switching transistors in the secondary-side circuit; and also prevent a current of the current transformer from being input to the integration filter circuit, thereby avoiding damage to the integration filter circuit. In addition, each group of controllable switches further includes a freewheeling resistor. When the four switching transistors in the secondary-side circuit are in a dead zone, a current of the integration filter circuit may be consumed via the freewheeling resistor, to protect the integration filter circuit.

With reference to the eighth possible implementation of the first aspect, in a ninth possible implementation, the switch circuit further includes a signal control circuit, the signal control circuit includes two groups of push-pull circuits, and the two groups of push-pull circuits are respectively correspondingly connected to the two groups of controllable switches. Each group of push-pull circuits includes two signal switching transistors, two voltage divider resistors, and one capacitor. One of the signal switching transistors is an N-channel switching transistor, and the other signal switching transistor is a P-channel switching transistor. A base of the one of the signal switching transistors is connected to the controller, an emitter of the one of the signal switching transistors is grounded, and a collector of the one of the signal switching transistors is connected in series to one voltage divider resistor and then is connected to a base of the other signal switching transistor. The base of the other signal switching transistor is connected in series to the other voltage divider resistor and then is grounded via the capacitor, an emitter of the other signal switching transistor is connected to the other voltage divider resistor and the capacitor, and a collector of the other signal switching transistor is connected to gates of two switching transistors in one group of controllable switches. The controller is configured to control a high level or a low level to be input to a base of the signal switching transistor, to control the two groups of controllable switches to be turned on or off.

With reference to the ninth possible implementation of the first aspect, in a tenth possible implementation, each group of push-pull circuits further includes other two protection resistors. One of the protection resistors is connected to a base of one of the signal switching transistors, and the other protection resistor is connected to a collector of the other signal switching transistor.

In this embodiment of this application, for one signal switching transistor that is in any group of push-pull circuits and that is connected to the controller, the protection resistor is disposed at a base of the signal switching transistor, and the protection resistor may share a part of the voltage. This avoids damage to the base of the switching transistor caused by an excessively high voltage $U_{GE}$ between the base and an emitter of the switching transistor. For the other signal switching transistor, the protection resistor has a similar function, and can prevent the switching transistor in the switch circuit from being damaged due to an excessively high voltage of a base and an emitter of the signal switching transistor.

With reference to any one of the first possible implementation to the tenth possible implementation of the first aspect, in an eleventh possible implementation, the integration filter circuit includes an operational amplifier, a filter resistor, and a filter capacitor. An inverting input end of the operational amplifier is connected in series to the filter resistor and then is connected to the two ends of the two sampling resistors connected in series. A non-inverting input end of the operational amplifier is connected to the connection midpoint of the two sampling resistors. Two ends of the filter capacitor are respectively connected to the inverting input end of the operational amplifier and an output end of the operational amplifier.

With reference to the eleventh possible implementation of the first aspect, in a twelfth possible implementation, the integration filter circuit further includes other two protection resistors. One of the protection resistors is connected in parallel to the two ends of the filter capacitor, and the other protection resistor is connected to the non-inverting input end of the operational amplifier.

In this embodiment of this application, in a process in which the integration filter circuit performs integration filtering on the sampling resistor, the filter capacitor is being charged for a long time, and the operational amplifier may be saturated soon. Because the protection resistor is connected in parallel to the two ends of the capacitor, a voltage at the two ends of the filter capacitor may be released via the protection resistor. In this way, the integration filter circuit is protected, so that the integration filter circuit can operate normally. In addition, the non-inverting input end of the integration filter circuit is connected in series to a protection resistor, and the protection resistor is connected to the connection point of the two sampling resistors. Generally, a reference bias voltage is set at the connection point. If there is no protection resistor, it is equivalent to that the connection point is directly connected to the non-inverting input end of the integration filter circuit, and the integration filter circuit is damaged.

With reference to any one of the first possible implementation to the twelfth possible implementation of the first aspect, in a thirteenth possible implementation, the sampling circuit, the switch circuit, the integration filter circuit, and the controller are integrated into a chip.

According to a second aspect, a current detection method is provided. The method is applied to an inverter. The method includes: controlling four switching transistors in a secondary-side circuit that is in the inverter and that is connected to a secondary-side winding of the transformer to be turned on or off, where the secondary-side circuit is configured to convert a frequency of an alternating current output by the secondary-side winding of the transformer into a power frequency alternating current, and output the power frequency alternating current to a power grid through an output port; and controlling, based on statuses of the four switching transistors and a current direction of the secondary-side winding of the transformer, two groups of controllable switches in a current detection circuit to be turned on or off, so that an integration filter circuit in the current detection circuit restores an output voltage of a sampling circuit in the current detection circuit, the current detection circuit is located between the secondary-side winding of the transformer and the secondary-side circuit, and a current, a voltage, or a frequency of an alternating current obtained through restoration of the integration filter circuit is consistent with that of the alternating current output by the output port.

With reference to the second aspect, in a first possible implementation, the controlling, based on statuses of the four switching transistors and a current direction of the secondary-side winding of the transformer, two groups of controllable switches to be turned on or off includes: when two switching transistors included in an upper half bridge arm are turned on or two switching transistors included in a lower half bridge arm are turned on, or when only one of the four switching transistors is turned on, controlling, based on the current direction of the secondary-side winding of the transformer, one group of controllable switches in the two groups of controllable switches to be turned on, and the other group of controllable switches to be turned off.

With reference to the second aspect, in a second possible implementation, the controlling, based on statuses of the four switching transistors and a current direction of the secondary-side winding of the transformer, two groups of controllable switches to be turned on or off includes: when one switching transistor in the upper half bridge arm and one switching transistor in the lower half bridge arm are turned on, when the two switching transistors in the upper half bridge arm and one switching transistor in the lower half bridge arm are turned on, or when one switching transistor in the upper half bridge arm and the two switching transistors in the lower half bridge arm are turned on, controlling, based on the current direction of the secondary-side winding of the transformer, the two groups of controllable switches to be alternately turned on or off.

With reference to the second possible implementation of the second aspect, in a third possible implementation, the upper half bridge arm includes a switching transistor S8 and a switching transistor S6, and the lower half bridge arm includes a switching transistor S5 and a switching transistor S7. The controlling, based on the current direction of the secondary-side winding of the transformer, the two groups of controllable switches to be alternately turned on or off includes: When the switching transistor S6 is turned on, the current direction of the secondary-side winding of the transformer is positive, and a controller controls, based on the positive current direction of the secondary-side winding of the transformer, one group of controllable switches to be turned on; or when the switching transistor S8 is turned on, the current direction of the secondary-side winding of the transformer is negative, a controller controls, based on the negative current direction of the secondary-side winding of the transformer, one group of controllable switches to be turned on; or when the switching transistor S5 is turned on, the current direction of the secondary-side winding of the transformer is positive, and a controller controls, based on the positive current direction of the secondary-side winding of the transformer, the other group of controllable switches to be turned on; or when the switching transistor S7 is turned on, the current direction of the secondary-side winding of the transformer is negative, and a controller controls, based on the negative current direction of the secondary-side winding of the transformer, the other group of controllable switches to be turned on.

For technical effect that may be achieved in the second aspect, refer to descriptions of the technical effect that may be achieved in any possible implementation of the first aspect. Details are not described herein again.

**BRIEF DESCRIPTION OF DRAWINGS**

FIG. 1 is a diagram of a microinverter system;
FIG. 2 is a schematic of a circuit topology of a microinverter;
FIG. 3 is a diagram of detecting an alternating current via a power frequency current transformer;
FIG. 4 is a diagram of a microinverter according to an embodiment of this application;
FIG. 5 is a diagram of another microinverter according to an embodiment of this application;
FIG. 6 is a diagram of still another microinverter according to an embodiment of this application;

FIG. 7 is a diagram of a current flow direction of a secondary-side circuit connected to a secondary-side winding of a transformer according to an embodiment of this application;

FIG. 8 is a diagram of yet another microinverter according to an embodiment of this application;

FIG. 9 is a diagram of another current flow direction of a secondary-side circuit connected to a secondary-side winding of a transformer according to an embodiment of this application;

FIG. 10 is a diagram of still yet another microinverter according to an embodiment of this application;

FIG. 11 is a diagram of still another current flow direction of a secondary-side circuit connected to a secondary-side winding of a transformer according to an embodiment of this application;

FIG. 12 is a diagram of a further microinverter according to an embodiment of this application;

FIG. 13 is a diagram of a current detection method according to an embodiment of this application;

FIG. 14 is a diagram of a still further microinverter according to an embodiment of this application;

FIG. 15 is a diagram of a yet further microinverter according to an embodiment of this application; and

FIG. 16 is a diagram of a current detection method according to an embodiment of this application.

## DESCRIPTION OF EMBODIMENTS

The following describes technical solutions of embodiments in this application with reference to accompanying drawings.

In the descriptions of embodiments of this application, unless otherwise specified, "/" means "or". For example, A/B may represent A or B. In this specification, "and/or" describes only an association relationship between associated objects and represents that three relationships may exist. For example, A and/or B may represent the following three cases: Only A exists, both A and B exist, and only B exists.

Prefix words "first", "second", and the like in embodiments of this application are merely intended to distinguish between different described objects, and impose no limitation on locations, sequences, priorities, quantities, content, or the like of the described objects. Use of prefixes such as ordinal numbers used to distinguish the described objects in embodiments of this application does not constitute a limitation on the described objects. For description of the described objects, refer to the context description in claims or embodiments, and the use of such prefixes should not constitute a redundant limitation. In addition, in description of embodiments, unless otherwise specified, "a plurality of" means two or more.

Reference to "some embodiments" or the like described in this specification indicates that one or more embodiments of this application include a specific feature, structure, or characteristic described with reference to embodiments. Therefore, statements such as "in some embodiments" that appear at different places in this specification do not necessarily mean referring to a same embodiment, instead, they mean "one or more but not all of embodiments", unless otherwise specifically emphasized. Terms "include", "contain", "have", and their variants all mean "include but are not limited to", unless otherwise specifically emphasized in another manner.

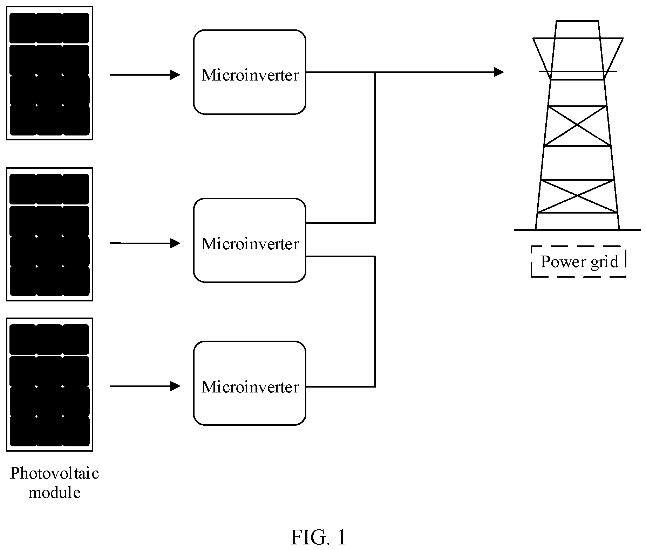

A microinverter can directly convert a direct current of a photovoltaic module into an alternating current, and is widely used in a photovoltaic power generation system in a residential scenario at present. FIG. 1 is a diagram of a microinverter system. One microinverter is connected to one photovoltaic module, and converts a direct current from the photovoltaic module into an alternating current. A plurality of microinverters are connected in parallel, and then output an alternating current to a power grid.

Because an alternating current connected to the power grid needs to meet a grid connection requirement of the power grid, detection of an alternating current on a grid connection side is very important. A parameter like an amplitude or a frequency of the detected alternating current plays an important role in closed-loop control of the microinverter in an operating process.

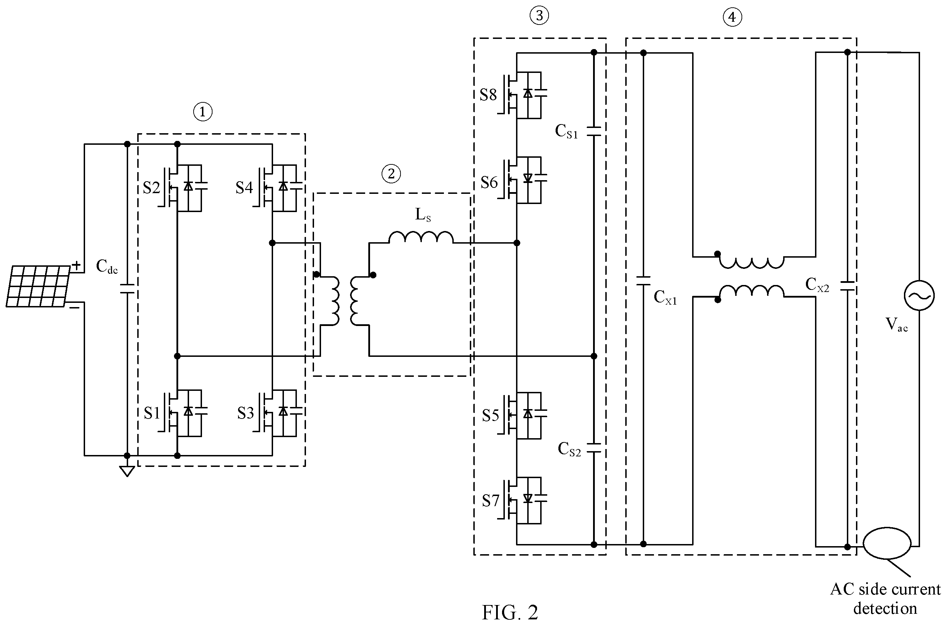

FIG. 2 is a schematic of a circuit topology of a microinverter. A primary-side circuit (that is, a dashed-line box 1) is formed by an H bridge, a transformer is in a dashed-line box 2 in the middle, and $L_s$ represents a transformer leakage inductor or an inductor connected in series to the transformer. A secondary-side circuit (that is, a dashed-line box 3) is a half-bridge circuit including four switching transistors (including S5, S6, S7, and S8) and two bridge capacitors (including $C_{S1}$ and $C_{S2}$) and is connected to an output filter (that is, a dashed-line box 4). A photovoltaic module converts solar energy into a direct current through photovoltaic effect. The direct current is converted into an alternating current after being inverted by the H bridge. The alternating current enters the half-bridge circuit after being transformed by the transformer. The half-bridge circuit converts the alternating current into a power frequency current, and the power frequency current obtained through conversion enters the power grid after being filtered by the filter.

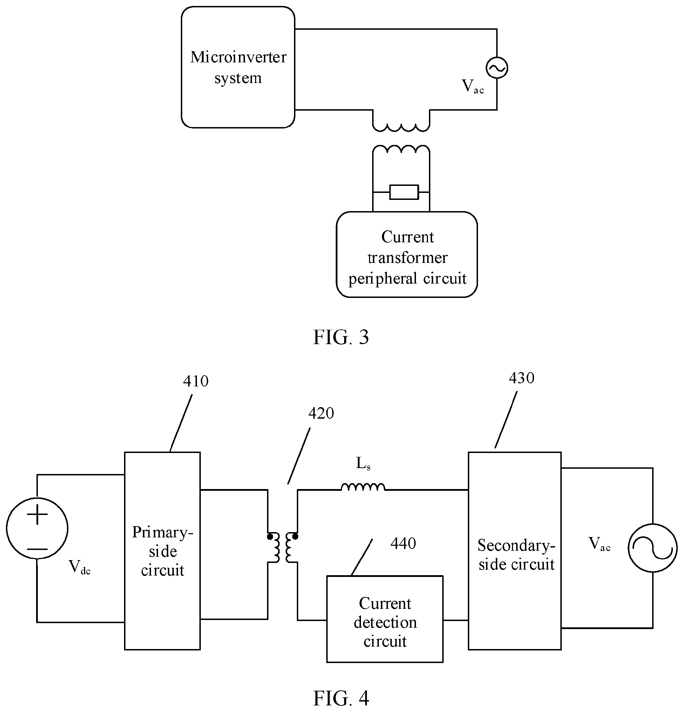

Currently, detection of an alternating current side current mainly focuses on disposing a sampling component at an alternating current grid connection port. The following describes an existing alternating current side current detection technology with reference to FIG. 3.

FIG. 3 is a diagram of detecting an alternating current via a power frequency current transformer. The power frequency current transformer and a back-end conversion circuit (for example, a resistor and a current transformer peripheral circuit in the figure) are added to the alternating current grid connection port to detect the grid-connected alternating current. However, the power frequency current transformer has a large size, is inconvenient to mount, is not applicable to a microinverter scenario, and has high costs.

In view of this, this application provides a microinverter. An alternating current detection circuit in the microinverter is disposed between a secondary-side winding of a transformer and a secondary-side circuit, and the alternating current detection circuit detects a high-frequency current of the secondary-side winding of the transformer. A higher current frequency indicates better signal transmission performance. Therefore, a current transformer in the alternating current detection circuit has a small volume and low costs, and is suitable for use in the microinverter.

FIG. 4 is a diagram of a microinverter according to an embodiment of this application. The microinverter includes a primary-side circuit 410, a transformer 420, a secondary-side circuit 430, and a current detection circuit 440.

One end of the primary-side circuit 410 is configured to input a direct current voltage $V_{dc}$, and the other end of the primary-side circuit 410 is connected to a primary-side winding of the transformer 420. The primary-side circuit 410 is configured to convert the direct current voltage $V_{dc}$ input by a photovoltaic module into an alternating current. The alternating current includes a high-frequency alternating current rectangular wave signal.

The primary-side circuit 410 in this embodiment of this application may be an H-bridge circuit, for example, a half-bridge circuit, a full-bridge circuit, or another circuit that can convert a direct current into a high-frequency alternating current. The primary-side circuit may include a plurality of H-bridge circuits. For example, a plurality of half-bridge circuits are connected in series or in parallel, or a half-bridge circuit and a full-bridge circuit are connected in series or in parallel. This is not limited.

The transformer 420 is configured to boost or buck the alternating current output by the primary-side circuit. The transformer 420 may be designed as a transformer whose amount of secondary-side leakage inductance is equal to that of $L_s$. Alternatively, refer to FIG. 4. The transformer 420 may be designed as a transformer with a very small amount of leakage inductance, and an inductive device $L_s$ connected in series is separately disposed. In this embodiment of this application, an example in which an inductor $L_s$ connected in series is separately disposed is used.

The secondary-side circuit 430 is configured to convert an alternating current obtained through boosting and bucking into a power frequency alternating current, and is configured to output the power frequency alternating current to a power grid through an output port.

In this embodiment of this application, a frequency of the alternating current output by a secondary-side winding of the transformer 420 is a high frequency, and the secondary-side circuit 430 may convert the high-frequency alternating current into the power frequency alternating current. The power frequency alternating current obtained through conversion further includes some clutters. The secondary-side circuit 430 may filter the power frequency alternating current obtained through conversion, and output a filtered alternating current to the power grid.

The current detection circuit 440 includes a current transformer, and the current transformer is located between the secondary-side winding of the transformer 420 and the secondary-side circuit 430. The current detection circuit 440 is configured to: collect the high-frequency alternating current of the secondary-side winding via the current transformer; and detect, based on the high-frequency alternating current, the alternating current output by the output port. A frequency of the high-frequency alternating current is greater than a frequency of the power frequency alternating current.

Generally, a relationship between an inductive reactance of a coil and both a frequency and an inductance is as follows: Inductive reactance=2*$\pi$*frequency*inductance. Because the frequency is in direct proportion to the inductive reactance, a higher frequency indicates a higher inductive reactance under a same condition, to be specific, a smaller quantity of turns are required for making the coil, and therefore a volume of the coil is smaller. Because the current detection circuit 440 in this embodiment of this application detects the high-frequency current of the secondary-side winding of the transformer 430, the current transformer in the current detection circuit 440 has a smaller volume than the power frequency current transformer in FIG. 3, and is suitable for use in the microinverter. In addition, because the current detection circuit 440 is located between the secondary-side winding of the transformer 420 and the secondary-side circuit 430, if the transformer 420 or the primary-side circuit 410 is faulty, in the solution shown in FIG. 3, a current needs to flow through the secondary-side circuit to detect the fault. As a result, a switching transistor in the secondary-side circuit is damaged. However, in this embodiment of this application, a fault current can be detected on the secondary-side winding side of the transformer. Therefore, in comparison with the solution of detecting an alternating current port in FIG. 3, in this embodiment of this application, fault detection can be performed on energy earlier, and therefore, response is faster, efficiency is higher, and faster response may be made to a fault.

In this embodiment of this application, the current detection circuit 440 is configured to detect an alternating current at a port of the power grid based on the high-frequency current of the secondary-side winding of the transformer 430, so that the alternating current at the port of the power grid is obtained by indirectly collecting the high-frequency current of the secondary-side winding of the transformer 420 instead of directly collecting the alternating current at the port of the power grid. The alternating current detection circuit 440 detects the high-frequency current of the secondary-side winding of the transformer 420, and a higher frequency indicates a smaller volume of the coil. Therefore, a component in the alternating current detection circuit 440 in this application has a smaller volume and lower costs, and is suitable for use in the microinverter. In addition, because the current detection circuit 440 is located between the secondary-side winding of the transformer 420 and the secondary-side circuit 430, a response speed and efficiency of identifying a fault that occurs in the transformer or the primary-side circuit are higher, and the inverter can be better protected.

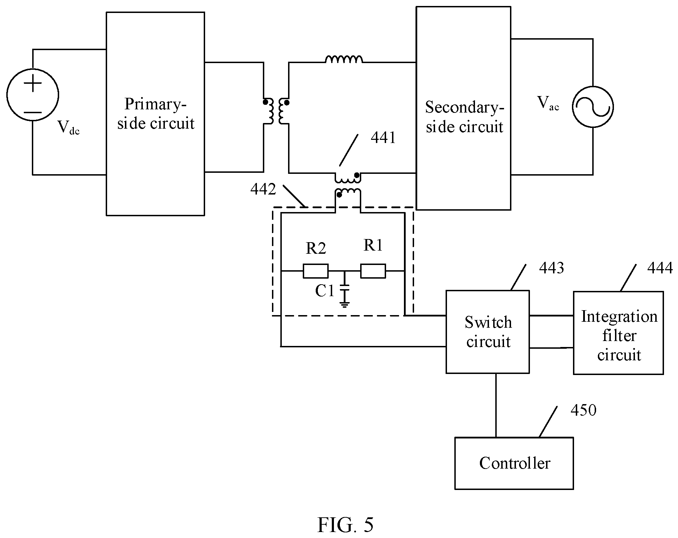

FIG. 5 is a diagram of another microinverter according to an embodiment of this application. In an embodiment, the microinverter further includes a controller 450. A current detection circuit 440 further includes a sampling circuit 442, a switch circuit 443, and an integration filter circuit 444. A primary side of a current transformer 441 is connected between a secondary-side winding of a transformer 420 and a secondary-side circuit 430. A secondary side of the current transformer 441 is connected to the sampling circuit 442. The sampling circuit 442 is connected to the integration filter circuit 444 via the switch circuit 443, and the switch circuit 443 includes a switching transistor.

The controller 450 is configured to control the switching transistor in the switch circuit 443 to be turned on or off, so that the integration filter circuit 444 restores an output voltage of the sampling circuit 442, and a current, a voltage, or a frequency of an alternating current obtained through restoration of the integration filter circuit is consistent with that of an alternating current output by an output port.

In an embodiment, the sampling circuit 442 includes two sampling resistors R1 and R2 and a sampling capacitor C1. The two sampling resistors R1 and R2 are connected in series and then connected to two ends of the secondary side of the current transformer 441. One end of the sampling capacitor C1 is connected to a connection midpoint of the two sampling resistors R1 and R2, and the other end is grounded.

In this embodiment of this application, the primary side of the current transformer 441 is connected between the secondary-side winding of the transformer 420 and the secondary-side circuit 430, and a high-frequency alternating current flowing out of the secondary-side winding of the transformer flows through the primary side of the current transformer 441. The current transformer 441 transmits the high-frequency alternating current to the secondary side of the current transformer 441 through electromagnetic induction. The high-frequency current flows through the two sampling resistors R1 and R2, and the integration filter circuit 444 performs integration filtering on a voltage at two ends of one of the sampling resistors. For a specific sampling resistor on which the integration filter circuit 444 performs integration filtering on a voltage at two ends, refer to the following description.

In this embodiment of this application, resistance values of the sampling resistors R1 and R2 are not excessively limited. In other words, the resistance values of the sampling resistors R1 and R2 may be equal or unequal. The current transformer 441 may be a down-current current transformer. The sampling circuit 442, the switch circuit 443, and the integration filter circuit 444 may be integrated into a chip, or the sampling circuit 442, the switch circuit 443, the integration filter circuit 444, and the following controller 450 may be integrated into a chip.

The integration filter circuit 444 performs integration filtering on a voltage at two ends of one of the sampling resistors. A parameter of a component in the integration filter circuit 444 is set, so that a waveform of a voltage output by the integration filter circuit 444 is basically consistent with a waveform of a current output by the secondary-side circuit. Therefore, the voltage output by the integration filter circuit 444 is an alternating current at a port of a power grid, so that the alternating current at the port of the power grid is obtained by indirectly collecting the high-frequency current of the secondary-side winding of the transformer 420 instead of directly collecting the alternating current at the port of the power grid. A parameter of the alternating current obtained through restoration of the integration filter circuit 444 is consistent with a parameter of the alternating current output by the output port, in other words, a waveform of the voltage output by the integration filter circuit 444 is basically consistent with a waveform of the current output by the secondary-side circuit. Therefore, whether the alternating current output by the secondary-side circuit meets a grid connection requirement may be determined based on the waveform of the voltage output by the integration filter circuit 444. When the grid connection requirement is met, the alternating current output by the microinverter is connected to the power grid, to ensure safety of the power grid. In addition, current data of a point of coupling is also an input parameter for implementing control on a circuit topology inside the microinverter. For example, the controller 450 may control, based on the voltage output by the integration filter circuit 444, switching transistors in the primary-side circuit and the secondary-side circuit in the microinverter to be turned on and off.

In this embodiment of this application, the controller 450 controls the switching transistor in the switch circuit to be turned on or off, so that the integration filter circuit 444 restores the output voltage of the sampling circuit. An alternating current obtained through restoration of the integration filter circuit is a consecutive alternating current at the port of the power grid, and parameters of the obtained alternating current at the port are more comprehensive and accurate, so that the alternating current output by the microinverter can be connected to the power grid. Therefore, safety of the power grid can be ensured.

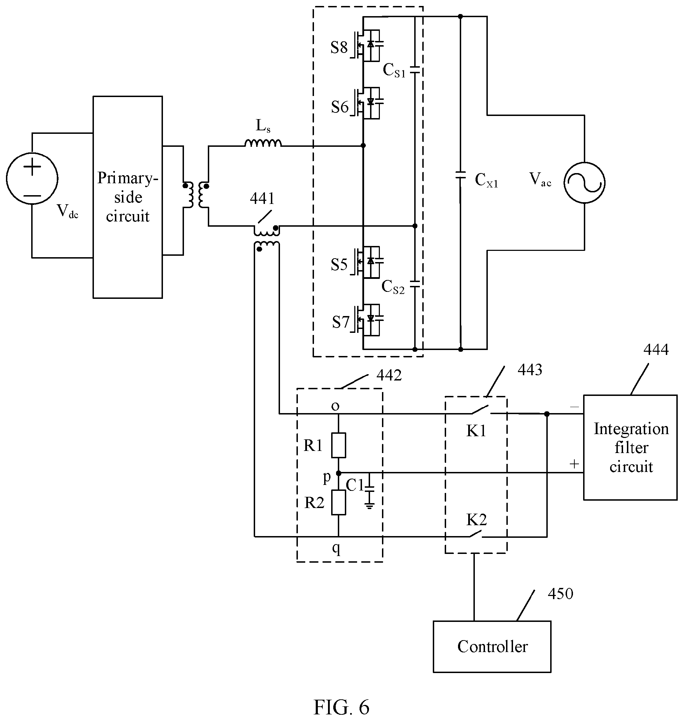

FIG. 6 is a diagram of still another microinverter according to an embodiment of this application. In an embodiment, a secondary-side circuit includes a bridge arm and two capacitors $C_{S1}$ and $C_{S2}$. The two capacitors $C_{S1}$ and $C_{S2}$ are connected in series and then connected in parallel to the bridge arm. The bridge arm includes an upper half bridge arm and a lower half bridge arm. A connection point of the upper half bridge arm and the lower half bridge arm is connected to one end of a secondary-side winding of a transformer 420, and a connection point of the two capacitors $C_{S1}$ and $C_{S2}$ is connected to the other end of the secondary-side winding of the transformer. The upper half bridge arm and the lower half bridge arm each include one group of switching transistors, and each group of switching transistors includes two switching transistors. Each of the two switching transistors includes one freewheeling diode connected in parallel, and freewheeling directions of the two freewheeling diodes connected in parallel to each group of switching transistors are opposite.

In this embodiment of this application, a switch circuit 443 includes two groups of controllable switches K1 and K2. One group of controllable switches K1 is connected between one end of two sampling resistors R1 and R2 connected in series and an inverting input end of an integration filter circuit 444, and one end of the sampling resistors connected in series is connected to a non-dotted terminal of the secondary-side winding of the transformer. The other group of controllable switches K2 is connected between the other end of the two sampling resistors R1 and R2 connected in series and the inverting input end of the integration filter circuit 444, and one end of the sampling resistors connected in series is connected to a dotted terminal of the secondary-side winding of the transformer. A connection midpoint of the two sampling resistors R1 and R2 is connected to a non-inverting input end of the integration filter circuit 444.

That the controller 450 is configured to control the switching transistors in the switch circuit 443 to be turned on or off, so that the integration filter circuit 444 restores an output voltage of a sampling circuit 442 includes: The controller 450 is configured to control, based on statuses of the four switching transistors included in the bridge arm and a current direction of the secondary-side winding of the transformer, the two groups of controllable switches to be turned on or off, so that the integration filter circuit 444 restores the output voltage of the sampling circuit 442.

In this embodiment of this application, the upper half bridge arm and the lower half bridge arm each include two switching transistors, and the two switching transistors included in each bridge arm form a bidirectional switch. The switching transistor in this embodiment of this application may be specifically a metal-oxide-semiconductor field-effect transistor (metal-oxide-semiconductor field-effect transistor, MOSFET), an insulated gate bipolar transistor (insulated gate bipolar transistor, IGBT), a gallium nitride (gallium nitride, GaN) high electron mobility transistor (high electron mobility transistor, HEMT), or the like. Specifically, the upper half bridge arm or the lower half bridge arm may include two discretely disposed switching transistors, or may include a module integrating two switching transistors, or may include a monolithic bidirectional (on or off) device (for example, a monolithic bidirectional GaN device). For example, the upper half bridge arm includes a switching transistor S8 and a switching transistor S6 connected in series, and the lower half bridge arm includes a switching transistor S5 and a switching transistor S7 connected in series.

Each switching transistor in this embodiment of this application includes a freewheeling diode connected in parallel, and the freewheeling diode may be referred to as a body-diode (body-diode).

Refer to FIG. 6. It can be learned that, when the controller 450 controls K1 to be turned on and K2 to be turned off, the integration filter circuit 444 is connected in parallel to two ends of R1, and the integration filter circuit 444 performs integration filtering on a voltage at the two ends of R1; or when the controller 450 controls K2 to be turned on and K1 to be turned off, the integration filter circuit 444 is connected in parallel to two ends of R2, and the integration filter circuit 444 performs integration filtering on a voltage at the two ends of R2.

In this embodiment of this application, on or off of the two groups of controllable switches in the switch circuit 443 is related to the statuses of the four switching transistors S8, S6, S5, and S7 in the bridge arm. For detailed content, refer to the following. A general principle is that the controller 450 controls the two groups of controllable switches to be turned on or off, so that a polarity of a voltage output by the integration filter circuit 444 is consistent with a polarity of a voltage output by the secondary-side circuit 430, and therefore, a waveform of the voltage output by the integration filter circuit 444 can be consistent with a waveform of a current of an alternating current at a port of a power grid.

In this embodiment of this application, the controller 450 controls, based on the statuses of the four switching transistors included in the bridge arm and the current direction of the secondary-side winding of the transformer 420, the two groups of controllable switches K1 and K2 to be turned on or off, so that the integration filter circuit 444 restores the output voltage of the sampling circuit. In addition, the polarity of the voltage output by the integration filter circuit 444 is consistent with the polarity of the voltage output by the secondary-side circuit 430, to ensure that the voltage output by the integration filter circuit 444 is the alternating current at the port of the power grid. Therefore, it is more reliable to obtain the alternating current at the port of the power grid based on the voltage output by the integration filter circuit 444. Further, this helps the microinverter invert a direct current output by a photovoltaic module into an alternating current and then connect the alternating current to the power grid, thereby ensuring safety of the power grid.

With reference to the accompanying drawings, the following describes, in different cases, that the controller 450 specifically controls, based on the statuses of the four switching transistors included in the bridge arm and the current direction of the secondary-side winding of the transformer 420, the two groups of controllable switches to be turned on or off.

In an embodiment, that the controller 450 is configured to control, based on the statuses of the four switching transistors included in the bridge arm and the current direction of the secondary-side winding of the transformer 420, the two groups of controllable switches to be turned on or off includes:

When the two switching transistors included in the upper half bridge arm are turned on or the two switching transistors included in the lower half bridge arm are turned on, or when only one of the four switching transistors is turned on, the controller 450 is configured to control, based on the current direction of the secondary-side winding of the transformer 420, one group of controllable switches in the two groups of controllable switches to be turned on and the other group of controllable switches to be turned off.

Case 1: The two switching transistors included in the upper half bridge arm are turned on.

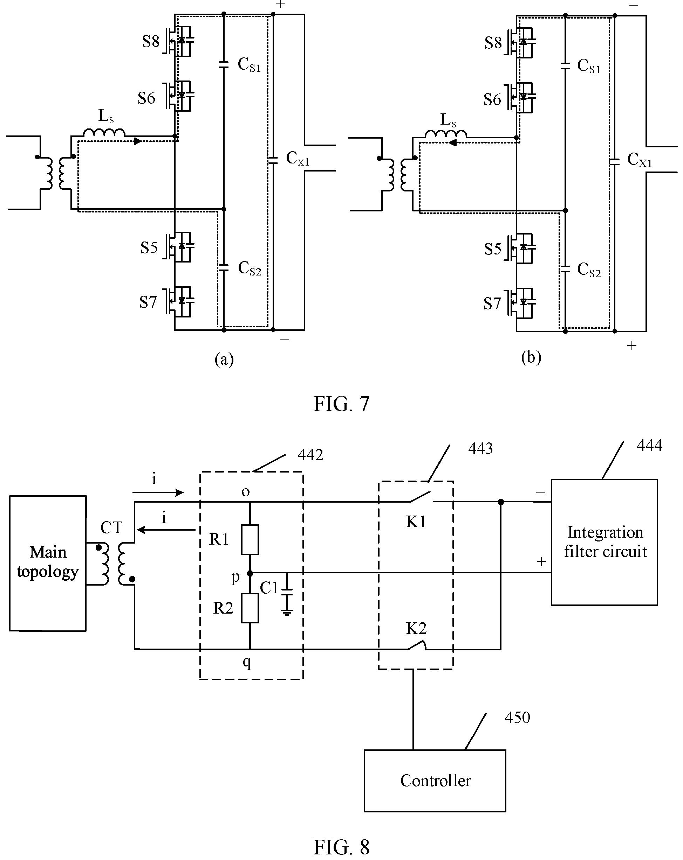

In this embodiment of this application, the switching transistors S8 and S6 in the upper half bridge arm are turned on, and there are two current directions of the secondary-side winding of the transformer. As shown in FIG. 7, one is from the dotted terminal of the secondary-side winding of the transformer to the non-dotted terminal of the secondary-side winding of the transformer through an inductor $L_s$, the switching transistor S6, the switching transistor S8, a filter capacitor $C_{X1}$, and the bridge capacitor $C_{S2}$ (as shown in (a) in FIG. 7). The other is from the non-dotted terminal of the secondary-side winding of the transformer to the dotted terminal of the secondary-side winding of the transformer through the bridge capacitor $C_{S2}$, the filter capacitor $C_{X1}$, the switching transistor S8, the switching transistor S6, and the inductor $L_s$ (as shown in (b) in FIG. 7). The two current loops have a same current path but different current directions.

In this embodiment of this application, a direction of a current on a secondary side of a current transformer CT from left to right is set to a positive direction, and a direction of the current on the secondary side of the current transformer CT from right to left is set to a negative direction.

(1) Refer to (a) in FIG. 7. For a current flowing out of the dotted terminal of the secondary-side winding of the transformer, a voltage at an output end of the secondary-side circuit is positive in an upper part and negative in a lower part (which may be referred to as a positive voltage for short below). To make the polarity of the voltage output by the integration filter circuit 444 consistent with a polarity of the voltage at the output end of the secondary-side circuit 430, the controller controls the controllable switch K2 to be turned on, as shown in FIG. 8. The current flows from the dotted terminal of the secondary-side winding of the transformer 420, and dotted terminals of the current transformer CT are not in a same direction. Therefore, a current direction of the secondary side of the current transformer CT is the positive direction, the current flows through the sampling resistors R1 and R2, and an electric potential at a point o is higher than an electric potential at a point q. The switch K2 is turned on, and the integration filter circuit 444 performs integration on the voltage at the two ends of the sampling resistor R2. An electric potential at a point p is higher than the electric potential at the point q at the two ends of the sampling resistor R2; and the point p is connected to the non-inverting input end of the integration filter circuit, and the point q is connected to the inverting input end of the integration filter circuit, in other words, the high-potential end of the sampling resistor R2 is connected to the non-inverting input end of the integration filter circuit, and the low-potential end of the sampling resistor R2 is connected to the inverting input end of the integration filter circuit, so that the voltage output by the integration filter circuit 444 is a positive voltage. Therefore, the polarity of the voltage output by the integration filter circuit 444 is consistent with the polarity of the voltage output by the secondary-side circuit 430, to ensure that the voltage output by the integration filter circuit 444 is the alternating current at the port of the power grid.

If the controller 450 controls the controllable switch K1 to be turned on, the integration filter circuit 444 performs integration on the voltage at the two ends of the sampling resistor R1. The electric potential at the point o of the sampling resistor R1 is higher than the electric potential at the point p; and the point o is connected to the inverting input end of the integration filter circuit, and the point p is connected to the non-inverting input end of the integration filter circuit, in other words, the high-potential end of the sampling resistor R1 is connected to the inverting input end of the integration filter circuit 444, and the low-potential end of the sampling resistor R1 is connected to the non-inverting input end of the integration filter circuit 444, so that the voltage output by the integration filter circuit 444 is a negative voltage, and the polarity of the voltage output by the integration filter circuit 444 is inconsistent with the polarity of the voltage output by the secondary-side circuit 430. As a result, the voltage output by the integration filter circuit 444 is inconsistent with the alternating current at the port of the power grid, and the alternating current at the port of the power grid cannot be obtained based on the voltage output by the integration filter circuit 444.

(2) Refer to (b) in FIG. 7. For a current flowing out of the non-dotted terminal of the secondary-side winding of the transformer, the voltage at the output end of the secondary-side circuit is negative in an upper part and positive in a lower part (which may be referred to as a negative voltage for short below). To make the polarity of the voltage output by the integration filter circuit 444 consistent with the polarity of the voltage at the output end of the secondary-side circuit 430, the controller controls the controllable switch K2 to be turned on, as shown in FIG. 8. The current flows from the non-dotted terminal of the secondary-side winding of the transformer, and the dotted terminals of the current transformer CT are not in a same direction. Therefore, a direction of a current on the secondary side of the current transformer is a negative direction, the current flows through the sampling resistors R1 and R2, and the electric potential at the point o is lower than the electric potential at the point q. The switch K2 is turned on, and the integration filter circuit 444 performs integration on the voltage at the two ends of the sampling resistor R2. The electric potential at the point p is lower than the electric potential at the point q at the two ends of the sampling resistor R2; and the point p is connected to the non-inverting input end of the integration filter circuit 444, and the point q is connected to the inverting input end of the integration filter circuit 444, in other words, the high-potential end of the sampling resistor R2 is connected to the inverting input end of the integration filter circuit 444, and the low-potential end of the sampling resistor R2 is connected to the non-inverting input end of the integration filter circuit 444, so that the voltage output by the integration filter circuit 444 is also a negative voltage. Therefore, the polarity of the voltage output by the integration filter circuit 444 is consistent with the polarity of the voltage output by the secondary-side circuit 430, to ensure that the voltage output by the integration filter circuit 444 is the alternating current at the port of the power grid.

If the controller 450 controls the controllable switch K1 to be turned on, the integration filter circuit performs integration on the voltage at the two ends of the sampling resistor R1. The electric potential at the point o of the sampling resistor R1 is lower than the electric potential at the point p; and the point o is connected to the inverting input end of the integration filter circuit 444, and the point p is connected to the non-inverting input end of the integration filter circuit 444, in other words, the high-potential end of the sampling resistor R1 is connected to the non-inverting input end of the integration filter circuit 444, and the low-potential end of the sampling resistor R1 is connected to the inverting input end of the integration filter circuit 444, so that the voltage output by the integration filter circuit 444 is a positive voltage. As a result, the polarity of the voltage output by the integration filter circuit 444 is inconsistent with the polarity of the voltage output by the secondary-side circuit 430, and the alternating current at the port of the power grid cannot be obtained based on the voltage output by the integration filter circuit 444.

Case 2: The two switching transistors included in the lower half bridge arm are turned on.

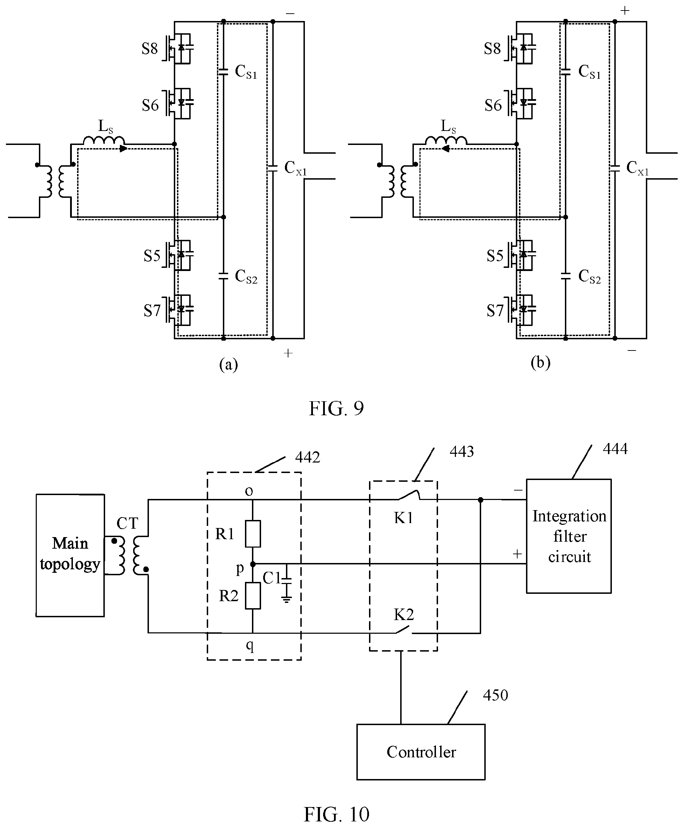

In this embodiment of this application, the switching transistors S5 and S7 in the lower half bridge arm are turned on, and there are two current directions of the secondary-side winding of the transformer. As shown in FIG. 9, one is from the dotted terminal of the secondary-side winding of the transformer to the non-dotted terminal of the secondary-side winding of the transformer through the inductor $L_s$, the switching transistor S5, the switching transistor S7, the filter capacitor $C_{X1}$, and the bridge capacitor $C_{S1}$ (as shown in (a) in FIG. 9). The other is from the non-dotted terminal of the secondary-side winding of the transformer to the dotted terminal of the secondary-side winding of the transformer through the bridge capacitor $C_{S1}$, the filter capacitor $C_{X1}$, the switching transistor S7, the switching transistor S5, and the inductor $L_s$ (as shown in (b) in FIG. 9). The two current loops have a same current path but different current directions.

(1) Refer to (a) in FIG. 9. For a current flowing out of the dotted terminal of the secondary-side winding of the transformer, a voltage at the output end of the secondary-side circuit is a negative voltage. To make the polarity of the voltage output by the integration filter circuit consistent with the polarity of the voltage at the output end of the secondary-side circuit, the controller 450 controls the controllable switch K1 to be turned on, as shown in FIG. 10. The switch K1 is turned on, the integration filter circuit 444 performs integration on the voltage at the two ends of the sampling resistor R1, and the dotted terminals of the current transformer CT are not in a same direction. Therefore, the direction of the current on the secondary side of the current transformer is positive, and a current flows through the sampling resistors R1 and R2. The electric potential at the point o of the sampling resistor R1 is higher than the electric potential at the point p; and the point o is connected to the inverting input end of the integration filter circuit 444, and the point p is connected to the non-inverting input end of the integration filter circuit 444, in other words, the high-potential end of the sampling resistor R1 is connected to the inverting input end of the integration filter circuit 444, and the low-potential end of the sampling resistor R1 is connected to the non-inverting input end of the integration filter circuit 444, so that the voltage output by the integration filter circuit 444 is also a negative voltage. Therefore, the polarity of the voltage output by the integration filter circuit 444 is consistent with the polarity of the voltage output by the secondary-side circuit 430, to ensure that the voltage output by the integration filter circuit 444 is the alternating current at the port of the power grid.

(2) Refer to (b) in FIG. 9. For a current flowing out of the non-dotted terminal of the secondary-side winding of the transformer, the voltage at the output end of the secondary-side circuit is a positive voltage. To make the polarity of the voltage output by the integration filter circuit 444 consistent with the polarity of the voltage at the output end of the secondary-side circuit 430, the controller controls the controllable switch K1 to be turned on, as shown in FIG. 10. The switch K1 is turned on, the integration filter circuit performs integration on the voltage at the two ends of the sampling resistor R1, and the dotted terminals of the current transformer CT are not in a same direction. Therefore, the current direction of the secondary side of the current transformer is negative, and a current flows through the sampling resistors R1 and R2. The electric potential at the point p of the sampling resistor R1 is higher than the electric potential at the point o; and the point p is connected to the non-inverting input end of the integration filter circuit 444, and the point o is connected to the inverting input end of the integration filter circuit 444, in other words, the high-potential end of the sampling resistor R1 is connected to the non-inverting input end of the integration filter circuit 444, and the low-potential end of the sampling resistor R1 is connected to the inverting input end of the integration filter circuit, so that the voltage output by the integration filter circuit 444 is also a positive voltage. Therefore, the polarity of the voltage output by the integration filter circuit 444 is consistent with the polarity of the voltage output by the secondary-side circuit 430, to ensure that the voltage output by the integration filter circuit 444 is the alternating current at the port of the power grid.

In a case in which only one of the four switching transistors is turned on, for a specific control strategy, refer to Case 1 or Case 2. Details are not described herein again.

In this embodiment of this application, when the two switching transistors included in the upper half bridge arm are turned on or the two switching transistors included in the lower half bridge arm are turned on, or when only one of the four switching transistors is turned on, the controller 450 is configured to control, based on the current direction of the secondary-side winding of the transformer 420 and the polarity of the voltage of the output end of the secondary-side circuit 430, one group of controllable switches in the two groups of controllable switches to be turned on and the other group of controllable switches to be turned off, to ensure that the voltage output by the integration filter circuit 444 is the alternating current at the port of the power grid. Therefore, it is more reliable to obtain the alternating current at the port of the power grid based on the voltage output by the integration filter circuit 444. Further, this helps the microinverter invert the direct current output by the photovoltaic module into the alternating current and then connect the alternating current to the power grid, thereby ensuring safety of the power grid.

In an embodiment, that the controller 450 is configured to control, based on the statuses of the four switching transistors included in the bridge arm and the current direction of the secondary-side winding of the transformer 420, the two groups of controllable switches to be turned on or off includes:

When one switching transistor in the upper half bridge arm and one switching transistor in the lower half bridge arm are turned on, when the two switching transistors in the upper half bridge arm and one switching transistor in the lower half bridge arm are turned on, or when one switching transistor in the upper half bridge arm and the two switching transistors in the lower half bridge arm are turned on, the controller 450 is configured to control, based on the current direction of the secondary-side winding of the transformer 420, the two groups of controllable switches to be alternately turned on or off.

In this embodiment of this application, when at least one switching transistor in the upper half bridge arm is turned on and at least one switching transistor in the lower half bridge arm is turned on, current directions of the secondary-side winding of the transformer may be the same but polarities of voltages of the output end of the secondary-side circuit may be different, or current directions of the secondary-side winding of the transformer may be different but polarities of voltages of the output end of the secondary-side circuit may be the same. Therefore, the controller 450 controls, based on specific on/off statuses of the switching transistors and the current direction of the secondary-side winding of the transformer 420, the two groups of controllable switches K1 and K2 to be alternately turned on or off, to ensure that the voltage output by the integration filter circuit 444 is the alternating current at the port of the power grid. Therefore, it is more reliable to obtain the alternating current at the port of the power grid based on the voltage output by the integration filter circuit 444. Further, this helps the microinverter invert the direct current output by the photovoltaic module into the alternating current and then connect the alternating current to the power grid, thereby ensuring safety of the power grid.

In an embodiment, the upper half bridge arm includes the switching transistor S8 and the switching transistor S6, and the lower half bridge arm includes the switching transistor S5 and the switching transistor S7. That the controller is configured to control, based on the current direction of the secondary-side winding of the transformer, the two groups of controllable switches to be alternately turned on or off includes:

When the switching transistor S6 is turned on, the current direction of the secondary-side winding of the transformer is positive, and the controller controls, based on the positive current direction of the secondary-side winding of the transformer, one group of controllable switches to be turned on; or when the switching transistor S8 is turned on, the current direction of the secondary-side winding of the transformer is negative, and the controller controls, based on the negative current direction of the secondary-side winding of the transformer, one group of controllable switches to be turned on.

When the switching transistor S5 is turned on, the current direction of the secondary-side winding of the transformer is positive, and the controller controls, based on the positive current direction of the secondary-side winding of the transformer, the other group of controllable switches to be turned on; or when the switching transistor S7 is turned on, the current direction of the secondary-side winding of the transformer is negative, and the controller controls, based on the negative current direction of the secondary-side winding of the transformer, the other group of controllable switches to be turned on.

In this embodiment of this application, it is assumed that a direction of the current of the secondary-side winding of the transformer from left to right is a positive direction, and a direction of current of the output end of the secondary-side circuit from top to bottom is a positive direction.

Case 3: At least the switching transistor S6 in the upper half bridge arm and the switching transistor S5 in the lower half bridge arm are turned on.

(1) The switching transistor S6 in the upper half bridge arm and the switching transistor S5 in the lower half bridge arm are turned on.

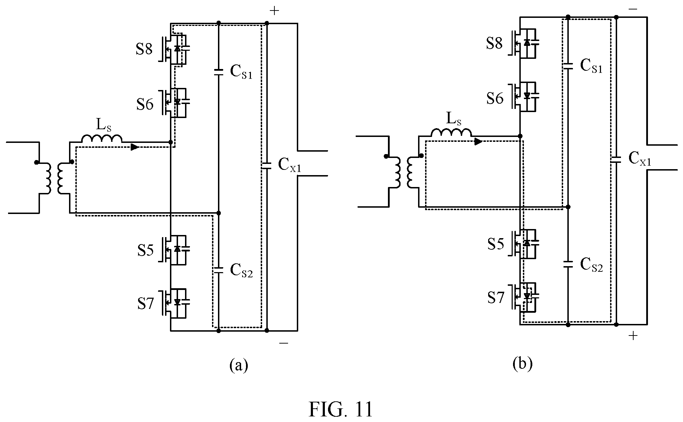

In this embodiment of this application, the switching transistor S6 in the upper half bridge arm and the switching transistor S5 in the lower half bridge arm are turned on, and there are two paths of current loops of the secondary-side winding of the transformer, as shown in FIG. 11. One is from the dotted terminal of the secondary-side winding of the transformer to the non-dotted terminal of the secondary-side winding of the transformer through the inductor $L_s$, the switching transistor S6, a freewheeling diode on the switching transistor S8, the filter capacitor $C_{X1}$, and the bridge capacitor $C_{S2}$, as shown in (a) in FIG. 11. The other is from the dotted terminal of the secondary-side winding of the transformer to the dotted terminal of the secondary-side winding of the transformer through the switching transistor S5, a freewheeling diode on the switching transistor S7, the filter capacitor $C_{X1}$, the bridge capacitor $C_{S1}$, and the inductor $L_s$, as shown in (b) in FIG. 11. The two current loops have different current paths, but a same current direction.

A. For the current loop passing through the switching transistor S6

Refer to (a) in FIG. 11. The current flow direction of the secondary-side winding of the transformer is positive, and the voltage at the output end of the secondary-side circuit is a positive voltage. To make the polarity of the voltage output by the integration filter circuit 444 consistent with the polarity of the voltage at the output end of the secondary-side circuit 430, the controller 450 controls the controllable switch K2 to be turned on. The current flows from the dotted terminal of the secondary-side winding of the transformer 420, the current direction of the secondary side of the current transformer is positive, and the current flows through the sampling resistors R1 and R2. The electric potential at the point o is higher than the electric potential at the point p. The switch K2 is turned on, and the integration filter circuit performs integration on the voltage at the two ends of the sampling resistor R2. The electric potential at the point p is higher than the electric potential at the point q at the two ends of the sampling resistor R2; and the point p is connected to the non-inverting input end of the integration filter circuit 444, and the point q is connected to the inverting input end of the integration filter circuit 444, in other words, the high-potential end of the sampling resistor R2 is connected to the non-inverting input end of the integration filter circuit 444, and the low-potential end of the sampling resistor R2 is connected to the inverting input end of the integration filter circuit 444, so that the voltage output by the integration filter circuit 444 is a positive voltage. Therefore, the polarity of the voltage output by the integration filter circuit 444 is consistent with the polarity of the voltage output by the secondary-side circuit 430, to ensure that the voltage output by the integration filter circuit 444 is the alternating current at the port of the power grid.

B. For the current loop passing through the switching transistor S5

Refer to (b) in FIG. 11. The current flow direction of the secondary-side winding of the transformer is positive, and the voltage at the output end of the secondary-side circuit is a negative voltage. To make the polarity of the voltage output by the integration filter circuit 444 consistent with the polarity of the voltage at the output end of the secondary-side circuit 430, the controller 450 controls the controllable switch K1 to be turned on. The switch K1 is turned on, and the integration filter circuit 444 performs integration on the voltage at the two ends of the sampling resistor R1. The electric potential at the point o of the sampling resistor R1 is higher than the electric potential at the point p; and the point o is connected to the inverting input end of the integration filter circuit 444, and the point p is connected to the non-inverting input end of the integration filter circuit 444, in other words, the high-potential end of the sampling resistor R1 is connected to the inverting input end of the integration filter circuit 444, and the low-potential end of the sampling resistor R1 is connected to the non-inverting input end of the integration filter circuit 444, so that the voltage output by the integration filter circuit 444 is also a negative voltage. Therefore, the polarity of the voltage output by the integration filter circuit 444 is consistent with the polarity of the voltage output by the secondary-side circuit 430, to ensure that the voltage output by the integration filter circuit 444 is the alternating current at the port of the power grid.

(2) The switching transistors S6 and S8 in the upper half bridge arm and the switching transistor S5 in the lower half bridge arm are turned on.

In this manner, in comparison with (1) in Case 3, there is one more current loop, to be specific, a current loop in which a current flows from the non-dotted terminal of the secondary-side winding of the transformer, and returns to the dotted terminal of the secondary-side winding of the transformer through the bridge capacitor $C_{S2}$, the filter capacitor $C_{X1}$, the switching transistor S8, the switching transistor S6, and the inductor $L_s$. According to the foregoing analysis of Case 1, in this manner, the controller controls the switch K2 to be turned on.

(3) The switching transistor S6 in the upper half bridge arm and the switching transistors S7 and S5 in the lower half bridge arm are turned on.

In this manner, in comparison with (1) in Case 3, there is one more current loop, to be specific, a current loop in which a current flows from the non-dotted terminal of the secondary-side winding of the transformer, and returns to the dotted terminal of the secondary-side winding of the transformer through the bridge capacitor $C_{S1}$, the filter capacitor $C_{X1}$, the switching transistor S7, the switching transistor S5, and the inductor $L_s$. According to the foregoing analysis of Case 2, in this manner, the controller controls the switch K1 to be turned on.

In conclusion, the controller may control, based on specific on/off statuses of the switching transistors and the current direction of the secondary-side winding of the transformer, the switch K1 or the switch K2 to be alternately turned on or off.

**Case 4: At least the switching transistor S8 in the upper half bridge arm and the switching transistor S7 in the lower half bridge arm are turned on.**

(1) The switching transistor S8 in the upper half bridge arm and the switching transistor S7 in the lower half bridge arm are turned on.

In this embodiment of this application, the switching transistor S8 in the upper half bridge arm and the switching transistor S7 in the lower half bridge arm are turned on, and there are two paths of current loops of the secondary-side winding of the transformer. One is from the non-dotted terminal of the secondary-side winding of the transformer to the dotted terminal of the secondary-side winding of the transformer through the bridge capacitor $C_{S2}$, the filter capacitor $C_{X1}$, the switching transistor S8, a freewheeling diode on the switching transistor S6, and the inductor $L_s$. The other is from the non-dotted terminal of the secondary-side winding of the transformer to the dotted terminal of the secondary-side winding of the transformer through the bridge capacitor $C_{S1}$, the filter capacitor $C_{X1}$, the switching transistor S7, a freewheeling diode on the switching transistor S5, and the inductor $L_s$. The two current loops have different current paths, but a same current direction.

A. For the current loop passing through the switching transistor S8

According to the foregoing analysis, the controller controls the switch K2 to be turned on.

B. For the current loop passing through the switching transistor S7

According to the foregoing analysis, the controller controls the switch K1 to be turned on.
(2) The switching transistors S8 and S6 in the upper half bridge arm and the switching transistor S7 in the lower half bridge arm are turned on.
In this manner, in comparison with (1) in Case 4, there is one more current loop, to be specific, a current loop in which the current flows from the non-dotted terminal of the secondary-side winding of the transformer, and returns to the dotted terminal of the secondary-side winding of the transformer through the bridge capacitor $C_{S2}$, the filter capacitor $C_{X1}$, the switching transistor S8, the switching transistor S6, and the inductor $L_s$. According to the foregoing analysis of Case 1, in this manner, the controller controls the switch K2 to be turned on.
(3) The switching transistor S8 in the upper half bridge arm and the switching transistors S7 and S5 in the lower half bridge arm are turned on.
In this manner, in comparison with (1) in Case 4, there is one more current loop, to be specific, a current loop in which the current flows from the non-dotted terminal of the secondary-side winding of the transformer, and returns to the dotted terminal of the secondary-side winding of the transformer through the bridge capacitor $C_{S1}$, the filter capacitor $C_{X1}$, the switching transistor S7, the switching transistor S5, and the inductor $L_s$. According to the foregoing analysis of Case 2, in this manner, the controller controls the switch K1 to be turned on.
In conclusion, the controller 450 may control, based on specific on/off statuses of the switching transistors and the current direction of the secondary-side winding of the transformer, the switch K1 or the switch K2 to be alternately turned on or off.
In this embodiment of this application, the controller 450 controls, based on specific on/off statuses of the switching transistors and the current direction of the secondary-side winding of the transformer, the two groups of controllable switches to be alternately turned on, to ensure that the voltage output by the integration filter circuit 444 is the alternating current at the port of the power grid. Therefore, it is more reliable to obtain the alternating current at the port of the power grid based on the voltage output by the integration filter circuit 444. Further, this helps the microinverter invert the direct current output by the photovoltaic module into the alternating current and then connect the alternating current to the power grid, thereby ensuring safety of the power grid.
In the foregoing embodiment, an example in which the switch circuit includes two groups of controllable switches K1 and K2 is used. The switch circuit may alternatively be a signal switching transistor. For details, refer to the following description.
In an embodiment, each group of controllable switches includes two switching transistors and one freewheeling resistor.
Sources of the two switching transistors in each group of controllable switches are connected. Drains of two switching transistors in one group of controllable switches are respectively connected to one end of the two sampling resistors connected in series and the inverting input end of the integration filter circuit 444. Drains of two switching transistors in the other group of controllable switches are respectively connected to the other end of the two sampling resistors connected in series and the inverting input end of the integration filter circuit 444. Each of the two switching transistors in each group of controllable switches includes a freewheeling diode connected in parallel, and freewheeling directions of the two freewheeling diodes connected in parallel to each group of controllable switches are opposite. Two ends of the freewheeling resistor are connected in parallel to drains of the two switching transistors.

Alternatively, drains of the two switching transistors in each group of controllable switches are connected. Sources of two switching transistors in one group of controllable switches are respectively connected to one end of the two sampling resistors connected in series and the inverting input end of the integration filter circuit 444. Sources of the two switching transistors in the other group of controllable switches are respectively connected to the other end of the two sampling resistors connected in series and the inverting input end of the integration filter circuit 444. Each of the two switching transistors in each group of controllable switches includes a freewheeling diode connected in parallel, and freewheeling directions of the two freewheeling diodes connected in parallel to each group of controllable switches are opposite. Two ends of the freewheeling resistor are connected in parallel to sources of the two switching transistors.

Gates of the two switching transistors in each group of controllable switches are connected, and the controller 450 is configured to control a high level or a low level to be input to the gates of the switching transistors, to control the two groups of controllable switches 443a to be turned on or off.

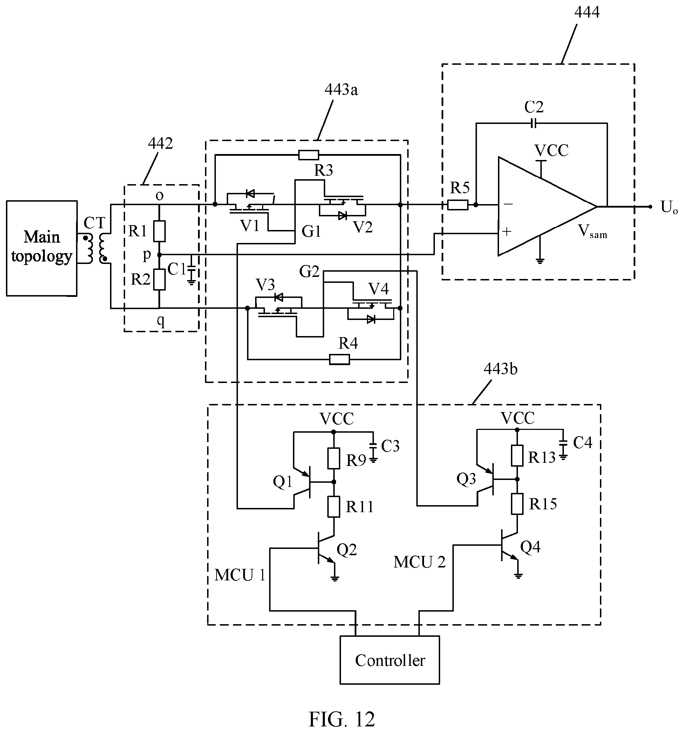

FIG. 12 is a diagram of a further microinverter according to an embodiment of this application. Sources of two switching transistors in each group of controllable switches shown in FIG. 12 are connected. For switching transistors V1 and V2 in one group, the switching transistors V1 and V2 are respectively connected to one end (a point o in the figure) of two sampling resistors connected in series and an inverting input end of an integration filter circuit 444. Drains of two switching transistors V3 and V4 in the other group of controllable switches are respectively connected to the other end (a point q in the figure) of the two sampling resistors connected in series and the inverting input end of the integration filter circuit 444. A freewheeling resistor R3 is connected in parallel to drains of the switching transistors V1 and V2.

It should be noted that each group of controllable switches shown in the figure includes two switching transistors, each of the two switching transistors is connected in parallel to a freewheeling diode, and freewheeling directions of the two diodes are opposite. In a switching process of four switching transistors S5 to S8, the switching transistors may be in a dead zone, to be specific, all the four switching transistors are turned off. In this case, a controller 450 controls all the switching transistors in the two groups of controllable switches to be turned off. The freewheeling directions of the two diodes connected in parallel to the two switching transistors in each group of switching transistors are opposite. Therefore, a current of the integration filter circuit can be prevented from being reversely input to a secondary-side circuit through a current transformer, to avoid damage to the switching transistors in the secondary-side circuit. In addition, a current of the current transformer can also be prevented from being input to the integration filter circuit, to prevent the integration filter circuit from being damaged.

In addition, each group of controllable switches further includes a freewheeling resistor, and the freewheeling resistor is connected in parallel to drains of the two switching transistors, to protect the integration filter circuit. As described above, in a switching process of the four switching transistors S5 to S8, the switching transistors may be in a dead zone, to be specific, all the four switching transistors are turned off. In this case, the controller 450 controls all the switching transistors in the two groups of controllable switches to be turned off. The freewheeling directions of the two diodes connected in parallel to the two switching transistors in each group of switching transistors are opposite. Therefore, the current of the integration filter circuit can be prevented from being reversely input to the secondary-side circuit through the current transformer. However, due to the freewheeling resistor, the current of the integration filter circuit may be consumed via the freewheeling resistor, thereby protecting the integration filter circuit.

In an embodiment, a switch circuit further includes a signal control circuit 443b. The signal control circuit 443b includes two groups of push-pull circuits, and the two groups of push-pull circuits are respectively correspondingly connected to the two groups of controllable switches 443a.

Each group of push-pull circuits includes two signal switching transistors, two voltage divider resistors, and one capacitor. One of the signal switching transistors is an N-channel switching transistor, and the other signal switching transistor is a P-channel switching transistor. A base of the one of the signal switching transistors is connected to the controller 450, an emitter of the one of the signal switching transistors is grounded, and a collector of the one of the signal switching transistors is connected in series to one voltage divider resistor and then is connected to a base of the other signal switching transistor. The base of the other signal switching transistor is connected in series to the other voltage divider resistor and then is grounded via the capacitor, an emitter of the other signal switching transistor is connected to the other voltage divider resistor and the capacitor, and a collector of the other signal switching transistor is connected to gates of two switching transistors in one group of controllable switches.

The controller 450 is configured to control a high level or a low level to be input to a base of the signal switching transistor, to control the two groups of controllable switches 443a to be turned on or off.

Refer to FIG. 12. For one group of push-pull circuits, a switching transistor Q2 is an N-channel switching transistor, and a switching transistor Q1 is a P-channel switching transistor. A base of the switching transistor Q2 is connected to the controller 450, an emitter of the switching transistor Q2 is grounded, and a collector of the switching transistor Q2 is connected in series to a voltage divider resistor R11, and then is connected to a base of the switching transistor Q1. The base of the switching transistor Q1 is connected in series to the other voltage divider resistor R9, and then is grounded via a capacitor C3, an emitter of the switching transistor Q1 is connected to the other voltage divider resistor R9 and the capacitor C3, and a collector of the other signal switching transistor Q1 is connected to gates of the two switching transistors V1 and V2 in one group of controllable switches.

It should be noted that the switching transistor Q2 connected to the controller 450 is the N-channel switching transistor, and the switching transistor Q1 connected to the gates of the switching transistors in the controllable switch is the P-channel switching transistor. Because the switching transistor Q2 connected to the controller is the N-channel switching transistor, the emitter of the switching transistor Q2 is grounded, the controller 450 controls a high level to be input to the base of the switching transistor Q2, and a voltage $U_{be}$ between the base and the emitter of the switching transistor Q2 is positive (it is assumed that $U_{be}$ is greater than a conduction voltage), the switching transistor Q2 is turned on. After the switching transistor Q2 is turned on, it is equivalent to that the collector of the switching transistor Q2 is also grounded. Because the collector of the switching transistor Q2 is connected to the base of the switching transistor Q1, it is equivalent to that the base of the switching transistor Q1 is grounded, and a VCC network connected to the emitter of the switching transistor Q1 outputs a positive voltage. Because the switching transistor Q1 is the P-channel switching transistor and a voltage $U_{be}$ between the base and the emitter of the switching transistor Q1 is negative, the switching transistor Q1 can be turned on. Further, V1 and V2 can be turned on.

If the switching transistor Q2 is a P-channel switching transistor and the switching transistor Q1 is an N-channel switching transistor, or both the switching transistor Q1 and the switching transistor Q2 are N-channel switching transistors or P-channel switching transistors, the solutions of this application cannot be implemented.

For example, the switching transistors Q1 and Q2 are both N-channel switching transistors. The controller 450 controls a high level to be input to the base of the switching transistor Q2, the voltage $U_{be}$ between the base and the emitter of the switching transistor Q2 is positive (it is assumed that $U_{be}$ is greater than the conduction voltage), and the switching transistor Q2 is turned on. After the switching transistor Q2 is turned on, it is equivalent to that the collector of the switching transistor Q2 is also grounded, and it is equivalent to that the base of the switching transistor Q1 is grounded. The VCC network connected to the emitter of the switching transistor Q1 outputs a positive voltage, and the voltage $U_{be}$ between the base and the emitter of the switching transistor Q1 is positive. Because the switching transistor Q1 is the N-channel switching transistor, the switching transistor Q1 cannot be turned on, and V1 and V2 cannot be turned on.

Similarly, an on/off principle of the switching transistors Q3 and Q4 is consistent with that of the switching transistors Q1 and Q2, and details are not described again.

It should be further noted that the signal control circuit 443b is not limited to the two groups of push-pull circuits shown in the foregoing embodiment, and the signal control circuit 443b may alternatively be an OC gate circuit or an OD gate circuit. This application may be applied to any circuit that can output a high level and a low level.

In an embodiment, the integration filter circuit includes an operational amplifier, a filter resistor R5, and a filter capacitor C2. An inverting input end of the operational amplifier is connected to the filter resistor in series, and then is connected to the two ends of the two sampling resistors connected in series. A non-inverting input end of the operational amplifier is connected to a connection midpoint of the two sampling resistors. Two ends of the filter capacitor C2 are respectively connected to the inverting input end of the operational amplifier and the output end of the operational amplifier.

In this embodiment of this application, a relationship between a voltage output by the integration filter circuit 444 and an input voltage is as follows:

$$U_o = -\frac{1}{R_5 C_2} \int_{t1}^{t2} U_i dt$$

$U_o$ is an output voltage of the integration filter circuit, $U_i$ is the input voltage of the integration filter circuit, and $t1$ and $t2$ are respectively start time and end time at which integration is performed on the input voltage.

In this embodiment of this application, on and turn of controllable switches K1 and K2 are related to on and off of the switching transistor in the secondary-side circuit 430. The integration filter circuit 444 performs integration filtering on the sampling resistor based on the on and off statuses of the controllable switches K1 and K2. Generally, when a turned-on switching transistor in the secondary-side circuit 430 changes, the start time at which the integration filter circuit 444 performs integration filtering on a voltage at the two ends of the sampling resistor starts to be recalculated.

For example, it is assumed that in a time period from 9:00 to 9:10, the switching transistors S8 and S6 in the secondary-side circuit 430 are turned on, the controller 450 controls the controllable switch K2 to be turned on, and the integration filter circuit 444 performs integration filtering on the voltage at the two ends of R2, that is,

$$U_o = -\frac{1}{R_5 C_2} \int_{9:00}^{9:10} U_2 dt$$ . It is assumed that in a time period from 9:10 to 9:15, the switching transistors S5 and S7 in the secondary-side circuit 430 are turned on, the controller 450 controls the controllable switch K1 to be turned on, and the integration filter circuit 444 performs integration filtering on the voltage at the two ends of R1, that is,

$$U_o = -\frac{1}{R_5 C_2} \int_{9:10}^{9:15} U_1 dt$$ . Therefore, the voltage output by the integration filter circuit 444 is consistent with an alternating current at a port of a power grid.

With reference to Table 1, the following lists output levels of G1 and G2 in cases in which different switching transistors are turned on. Table 1 lists only some possible cases.

**Table 1**

| Statuses of S5, S6, S7, and S8 | | G1 | G2 |
|---|---|---|---|
| Only one switching transistor is turned on | S5 | High level | Low level |
| | S6 | Low level | High level |
| Only switching transistors in an upper half bridge arm or only switching transistors in a lower half bridge arm are turned on | S8 and S6 | Low level | High level |
| | S5 and S7 | High level | Low level |
| At least one switching transistor in the upper half bridge arm and at least one switching transistor in the lower half bridge arm are turned on | S8 and S5 | High level | High level |
| | S8 and S7 | High level | High level |
| | S8, S6, and S5 | High level | High level |
| | S8, S6, and S7 | High level | High level |

Refer to Table 1. It can be learned that, for cases in which only one switching transistor is turned on, or only the switching transistors in the upper half bridge arm or only the switching transistors in the lower half bridge arm are turned on, the controller controls G1 or G2 to output a high level, to be specific, controls V1 and V2 to be turned on, or controls V3 and V4 to be turned on. For a case in which at least one switching transistor in the upper half bridge arm and at least one switching transistor in the lower half bridge arm are turned on, the controller controls G1 and G2 to alternately output a high level, to be specific, controls the switching transistors V1 and V in one group and the switching transistors V3 and V4 in one group to be alternately turned on.

The following separately provides descriptions by using examples in which only the switching transistors in the upper half bridge arm are turned on, and at least one switching transistor in the upper half bridge arm and at least one switching transistor in the lower half bridge arm are turned on.

Case 1: The two switching transistors S8 and S6 included in the upper half bridge arm are turned on.

As described above, the switching transistors S8 and S6 are turned on, and there are two current directions of a secondary-side winding of a transformer, for example, (a) in FIG. 7 and (b) in FIG. 7. Two current loops have a same current path but different current directions.

(1) Refer to (a) in FIG. 7. For a current flowing out of a dotted terminal of the secondary-side winding of the transformer, a voltage at an output end of the secondary-side circuit is positive in an upper part and negative in a lower part (which may be referred to as a positive voltage for short below). To make a polarity of a voltage output by the integration filter circuit consistent with a polarity of the voltage output by the secondary-side circuit, the controller controls the switching transistors V3 and V4 to be turned on, so that the polarity of the voltage output by the integration filter circuit is consistent with the polarity of the voltage output by the secondary-side circuit. Therefore, to turn on the switching transistors V3 and V4, the controller controls a gate of the switching transistor Q4 to output a high level. When a high level is input to the gate of the switching transistor Q4, because an emitter of the switching transistor Q4 is grounded, a voltage $U_{GE}$ between the gate and the emitter of the switching transistor Q4 is a positive voltage. Therefore, the switching transistor Q4 is turned on. When the switching transistor Q4 is turned on, it is equivalent to that a collector of the switching transistor Q4 is grounded. Because an emitter of the switching transistor Q3 is connected to the capacitor C3, a voltage $U_{GE}$ between a gate and the emitter of the switching transistor Q3 is a negative voltage. Therefore, the switching transistor Q3 is turned on. A collector of the switching transistor Q3 is connected to G2 in the controllable switch, that is, a high level is input to G2, so that the switching transistors V3 and V4 are turned on.

(2) Refer to (b) in FIG. 7. For a current flowing out of a non-dotted terminal of the secondary-side winding of the transformer, a control strategy is similar to that described above, and details are not described again.

Case 3: At least the switching transistor S6 in the upper half bridge arm and the switching transistor S5 in the lower half bridge arm are turned on.

(1) The switching transistor S6 in the upper half bridge arm and the switching transistor S5 in the lower half bridge arm are turned on.

As described above, the switching transistors S6 and S5 are turned on, and there are two paths of current loops of the secondary-side winding of the transformer. As shown in (a) in FIG. 11 and (b) in FIG. 11, the two current loops have different current paths, but a same current direction.

A. For a current loop passing through the switching transistor S6

Refer to (a) in FIG. 11. The current flow direction of the secondary-side winding of the transformer 420 is positive, and the voltage at the output end of the secondary-side circuit 430 is a positive voltage. To make the polarity of the voltage output by the integration filter circuit 444 consistent with the polarity of the voltage at the output end of the secondary-side circuit 430, the controller 450 controls the switching transistors V3 and V4 to be turned on, so that the polarity of the voltage output by the integration filter circuit 444 is consistent with the polarity of the voltage output by the secondary-side circuit 430. Therefore, to turn on the switching transistors V3 and V4, the controller 450 controls the gate of Q4 to output a high level, so that a high level is finally input to G2, to turn on the switching transistors V3 and V4.

B. For a current loop passing through the switching transistor S5

Refer to (b) in FIG. 11. The current flow direction of the secondary-side winding of the transformer 420 is positive, and the voltage at the output end of the secondary-side circuit 430 is a negative voltage. To make the polarity of the voltage output by the integration filter circuit 444 consistent with the polarity of the voltage at the output end of the secondary-side circuit 430, the controller 450 controls the switching transistors V1 and V2 to be turned on, so that the polarity of the voltage output by the integration filter circuit 444 is consistent with the polarity of the voltage output by the secondary-side circuit 430. Therefore, to turn on the switching transistors V1 and V2, the controller 450 controls a gate of Q2 to output a high level, so that a high level is finally input to G1, to turn on the switching transistors V1 and V2.

In conclusion, for the case in which at least the switching transistor S6 in the upper half bridge arm and the switching transistor S5 in the lower half bridge arm are turned on, the controller controls, based on the current direction of the secondary-side winding of the transformer and the polarity of the voltage of the output end of the secondary-side circuit, the switching transistors V1 and V2 or the switching transistors V3 and V4 to be alternately turned on or off.

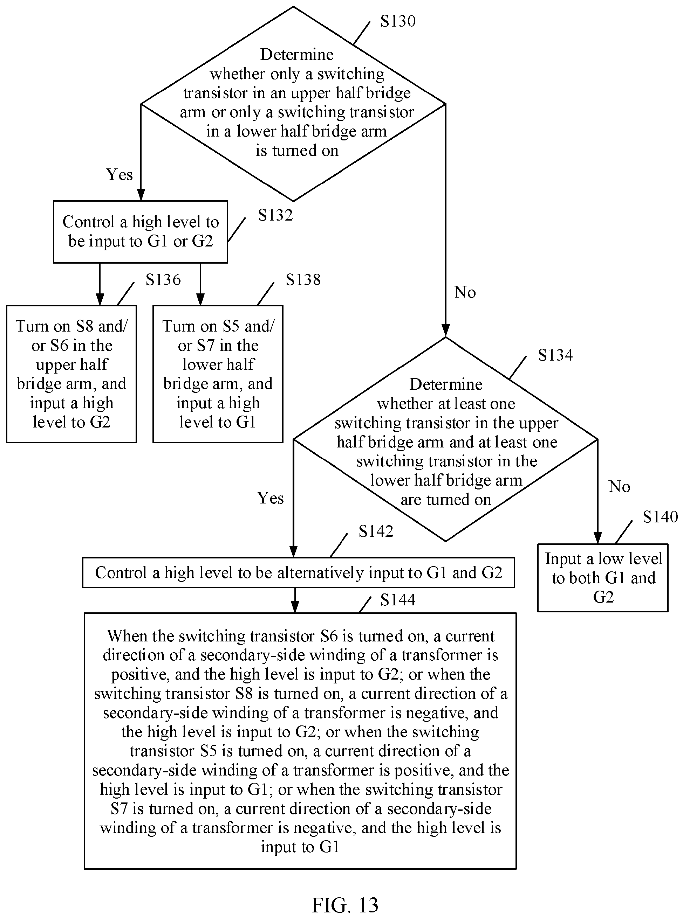

To better understand the solutions of this application, the following provides descriptions with reference to FIG. 13. FIG. 13 is a diagram of a current detection method according to an embodiment of this application. The current detection method may include steps S130 to S144.

S130: Determine whether only a switching transistor in an upper half bridge arm or only a switching transistor in a lower half bridge arm is turned on.

If yes, step S132 is performed; or if no, step S314 is performed.

S312: Control a high level to be input to G1 or G2.

Specifically, in S316, turn on S8 and/or S6 in the upper half bridge arm, and input a high level to G2. S318: Turn on S5 and/or S7 in the lower half bridge arm, and input a high level to G1.

S314: Determine whether at least one switching transistor in the upper half bridge arm and at least one switching transistor in the lower half bridge arm are turned on.

If no, step S140 is performed; or if yes, step S142 is performed.

S140: Input a low level to both G1 and G2.

S142: Control a high level to be alternately input to G1 and G2.

Specifically, in S144, when the switching transistor S6 is turned on, a current direction of a secondary-side winding of a transformer is positive, and a high level is input to G2; or when the switching transistor S8 is turned on, a current direction of a secondary-side winding of a transformer is negative, and a high level is input to G2; or when the switching transistor S5 is turned on, a current direction of a secondary-side winding of a transformer is positive, and a high level is input to G1; or when the switching transistor S7 is turned on, a current direction of a secondary-side winding of a transformer is negative, and a high level is input to G1.

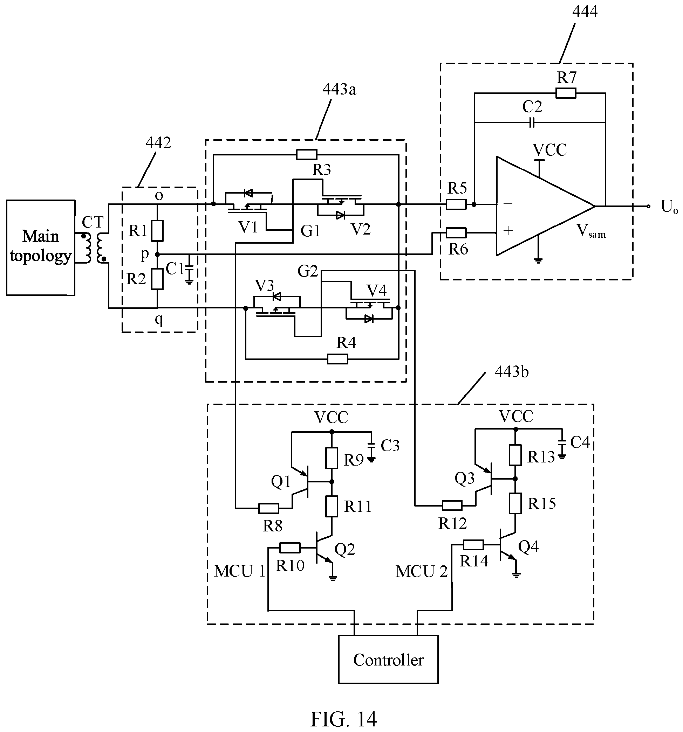

FIG. 14 is a diagram of a still further microinverter according to an embodiment of this application. In an embodiment, each group of push-pull circuits further includes other two protection resistors. One of the protection resistors is connected to a base of one signal switching transistor, and the other protection resistor is connected to a collector of the other signal switching transistor.

In this embodiment of this application, one group of push-pull circuits may further include other two protection resistors R8 and R10. The protection resistor R10 is connected to a base of a switching transistor Q2, and the other protection resistor R8 is connected to a collector of the other switching transistor Q1. The other group of push-pull circuits may further include other two protection resistors R12 and R14. The protection resistor R14 is connected to a base of a switching transistor Q4, and the other protection resistor R12 is connected to a collector of the other switching transistor Q3.

In this embodiment of this application, main functions of the protection resistors R8 and R10 are to protect the switching transistors in the push-pull circuit. For example, the controller 450 controls a high level to be input to the base of the switching transistor Q2, and a voltage of the base of the switching transistor Q2 is greater than a voltage of an emitter. If a voltage $U_{be}$ between the base and the emitter of the switching transistor Q2 is greater than a conduction voltage, the switching transistor Q2 may be turned on. However, if the voltage $U_{be}$ between the base and the emitter of the switching transistor Q2 is excessively large, voltage oscillation of the base is caused, and consequently the base is damaged. In this embodiment of this application, the protection resistor R10 is disposed at the base of the switching transistor Q2, and the protection resistor R10 may share a part of the voltage. In this way, damage to the base of the switching transistor Q2 caused by an excessively large voltage $U_{be}$ between the base and the emitter of the switching transistor Q2 is prevented. In addition, the protection resistor R10 may further limit a current. If a voltage difference between a voltage of an MCU 1 and the voltage $U_{be}$ between the base and the emitter of the switching transistor Q2 is large, when there is no protection resistor R10, a current flowing through the base of the switching transistor Q2 is large. As a result, the switching transistor Q2 is damaged. In this embodiment of this application, the protection resistor R10 is disposed on the base of the switching transistor Q2. Because resistance increases, the current flowing through the base of the switching transistor Q2 can be reduced, to protect the switching transistor Q2. A function of the protection resistor R8 is similar, and details are not described again.

Functions of the protection resistors R12 and R14 are similar to functions of the protection resistors R8 and R10, and details are not described again.

In an embodiment, an integration filter circuit 444 further includes other two protection resistors R6 and R7. The protection resistor R7 is connected in parallel to two ends of a filter capacitor C2, and the other protection resistor R6 is connected to a non-inverting input end of an operational amplifier.

In this embodiment of this application, a non-inverting input end of the integration filter circuit 444 is connected in series to the protection resistor R6, and then is connected to a connection point (a point p in the figure) of two sampling resistors R1 and R2. Generally, a reference bias voltage $V_{ref}$ is set at the point p. If there is no protection resistor R6, it is equivalent to that the point p is directly connected to the non-inverting input end of the integration filter circuit 444. The integration filter circuit may be damaged due to voltage fluctuation. In this embodiment of this application, the protection resistor R6 is connected in series to the non-inverting input end of the operational amplifier. Even if a voltage fluctuates, the protection resistor R6 can reduce interference to the integration filter circuit caused by the voltage fluctuation, and reduce a possibility of damage to the integration filter circuit, to protect the integration filter circuit.

A main function of the protection resistor R7 is to prevent the integration filter circuit 444 from failing to operate normally because the operational amplifier enters a saturation state. In a process in which the integration filter circuit 444 performs integration filtering on the sampling resistor, the filter capacitor C2 is being charged for a long time, and the operational amplifier may be saturated soon. Because the protection resistor R7 is connected in parallel to two ends of the capacitor C2, a voltage at the two ends of the filter capacitor C2 may be released via the protection resistor R7. In this way, the integration filter circuit 444 is protected, so that the integration filter circuit 444 can operate normally.

It should be noted that, in the foregoing example, an example in which the switching transistors Q1 to Q4 are triodes is used for description. In some embodiments, the switching transistors Q1 to Q4 may alternatively be MOSFETs. This is not limited.

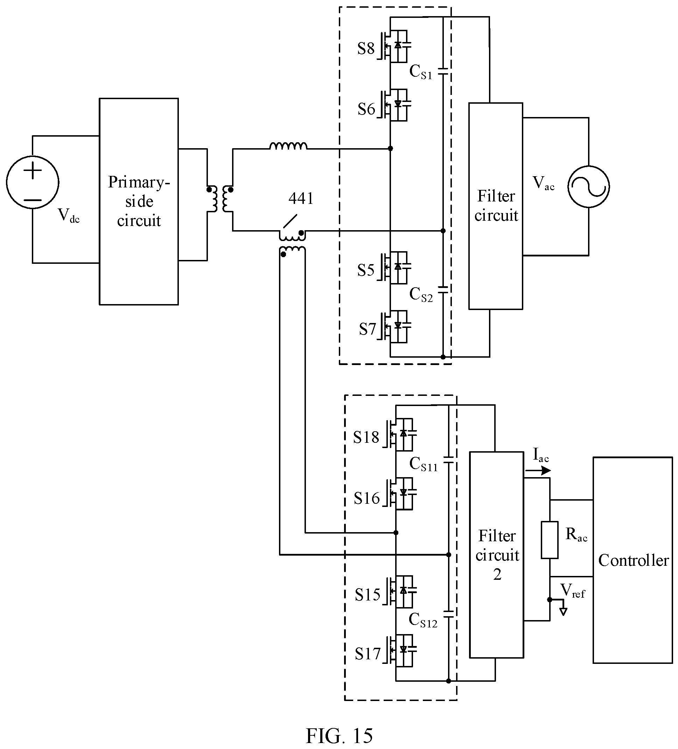

In view of this, the foregoing describes a structure of the current detection circuit and a corresponding control strategy. In some embodiments, the current detection circuit may alternatively be of a structure in another form, which is described below with reference to FIG. 15.

FIG. 15 is a diagram of a yet further microinverter according to an embodiment of this application. In this embodiment of this application, a current detection circuit shown in FIG. 15 is basically the same as a circuit in a main topology. On/off logic of switching transistors S15, S16, S17, and S18 shown in the figure is respectively the same as on/off logic of switching transistors S5, S6, S7, and S8, and capacities of capacitors $C_{S11}$ and $C_{S12}$ are the same as capacities of capacitors $C_{S1}$ and $C_{S2}$ in the main topology. A filter circuit 2 has same filtering effect as a filter circuit in the main topology.

A sampling resistor $R_{ac}$ and a direct current bias circuit are configured to convert a current into a voltage, to facilitate sampling processing of a controller. $V_{ref}$ is a bias voltage.

In this embodiment of this application, the controller may obtain an alternating current of a power grid port based on a voltage at two ends of the sampling resistor $R_{ac}$ and a resistance value of the sampling resistor $R_{ac}$.

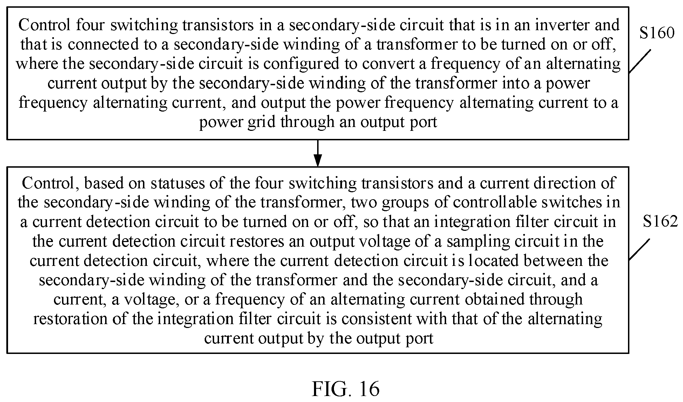

FIG. 16 is a diagram of a current detection method according to an embodiment of this application. It should be understood that descriptions of the method embodiments correspond to descriptions of the apparatus embodiments. Therefore, for content that is not described in detail, refer to the foregoing apparatus embodiments. Details are not described again.

The current detection method is applied to an inverter, and the current detection method includes steps S160 to S162.

S160: Control four switching transistors in a secondary-side circuit that is in the inverter and that is connected to a secondary-side winding of a transformer to be turned on or off, where the secondary-side circuit is configured to convert a frequency of an alternating current output by the secondary-side winding of the transformer into a power frequency alternating current, and output the power frequency alternating current to a power grid through an output port.

S162: Control, based on statuses of the four switching transistors and a current direction of the secondary-side winding of the transformer, two groups of controllable switches in a current detection circuit to be turned on or off, so that an integration filter circuit in the current detection circuit restores an output voltage of a sampling circuit in the current detection circuit, where the current detection circuit is located between the secondary-side winding of the transformer and the secondary-side circuit, and a current, a voltage, or a frequency of an alternating current obtained through restoration of the integration filter circuit is consistent with that of the alternating current output by the output port.

In an embodiment, the controlling, based on statuses of the four switching transistors and a current direction of the secondary-side winding of the transformer, two groups of controllable switches to be turned on or off includes: when two switching transistors included in an upper half bridge arm are turned on or two switching transistors included in a lower half bridge arm are turned on, or when only one of the four switching transistors is turned on, controlling, based on the current direction of the secondary-side winding of the transformer, one group of controllable switches in the two groups of controllable switches to be turned on, and the other group of controllable switches to be turned off.

In an embodiment, the controlling, based on statuses of the four switching transistors and a current direction of the secondary-side winding of the transformer, two groups of controllable switches to be turned on or off includes: when one switching transistor in the upper half bridge arm and one switching transistor in the lower half bridge arm are turned on, when the two switching transistors in the upper half bridge arm and one switching transistor in the lower half bridge arm are turned on, or when one switching transistor in the upper half bridge arm and the two switching transistors in the lower half bridge arm are turned on, controlling, based on the current direction of the secondary-side winding of the transformer, the two groups of controllable switches to be alternately turned on or off.

In an embodiment, the upper half bridge arm includes a switching transistor S8 and a switching transistor S6, and the lower half bridge arm includes a switching transistor S5 and a switching transistor S7. The controlling, based on the current direction of the secondary-side winding of the transformer, the two groups of controllable switches to be alternately turned on or off includes: When the switching transistor S6 is turned on, the current direction of the secondary-side winding of the transformer is positive, and a controller controls, based on the positive current direction of the secondary-side winding of the transformer, one group of controllable switches to be turned on; or when the switching transistor S8 is turned on, the current direction of the secondary-side winding of the transformer is negative, a controller controls, based on the negative current direction of the secondary-side winding of the transformer, one group of controllable switches to be turned on; or when the switching transistor S5 is turned on, the current direction of the secondary-side winding of the transformer is positive, and a controller controls, based on the positive current direction of the secondary-side winding of the transformer, the other group of controllable switches to be turned on; or when the switching transistor S7 is turned on, the current direction of the secondary-side winding of the transformer is negative, and a controller controls, based on the negative current direction of the secondary-side winding of the transformer, the other group of controllable switches to be turned on.

An embodiment of this application further provides a computer-readable storage medium. The computer-readable storage medium stores computer instructions used to implement the method performed by the controller in the foregoing method embodiments.

An embodiment of this application further provides a computer program product including instructions. The instructions are executed by a computer, so that the computer implements the method performed by a controller in the foregoing method embodiments.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A microinverter, comprising:

a primary-side circuit, wherein the primary-side circuit is configured to connect to a photovoltaic module, and convert a direct current output by the photovoltaic module into an alternating current;

a transformer, wherein a primary-side winding of the transformer is coupled to the primary-side circuit, and the transformer is configured to boost or buck the alternating current obtained through conversion of the primary-side circuit;

a secondary-side circuit, wherein a secondary-side winding of the transformer is coupled to the secondary-side circuit, and the secondary-side circuit is configured to: convert an alternating current obtained through boosting and bucking into a power frequency alternating current, and output the power frequency alternating current to a power grid through an output port; and

a current detection circuit, wherein the current detection circuit comprises a current transformer, the current transformer is located between the secondary-side winding of the transformer and the secondary-side circuit, the current detection circuit is configured to collect a high-frequency alternating current of the secondary-side winding via the current transformer, and detect, based on the high-frequency alternating current, the alternating current output by the output port, and a frequency of the high-frequency alternating current is greater than a frequency of the power frequency alternating current.

2. The microinverter according to claim 1, wherein the microinverter further comprises a controller, the current detection circuit further comprises a sampling circuit, a switch circuit, and an integration filter circuit, a primary side of the current transformer is connected between the secondary-side winding of the transformer and the secondary-side circuit, a secondary side of the current transformer is connected to the sampling circuit, the sampling circuit is connected to the integration filter circuit via the switch circuit, and the switch circuit comprises a switching transistor; and

the controller is configured to:

control the switching transistor in the switch circuit to be turned on or off, so that the integration filter circuit restores an output voltage of the sampling circuit, wherein a current, a voltage, or a frequency of an alternating current obtained through restoration of the integration filter circuit is consistent with that of the alternating current output by the output port.

3. The microinverter according to claim 2, wherein the sampling circuit comprises two sampling resistors and a sampling capacitor, the two sampling resistors are connected in series and then connected to two ends of the secondary side of the current transformer, one end of the sampling capacitor is connected to a connection midpoint of the two sampling resistors, and the other end is grounded.

4. The microinverter according to claim 2 or 3, wherein the secondary-side circuit comprises a bridge arm and two capacitors, the two capacitors are connected in series and then connected in parallel to the bridge arm, the bridge arm comprises an upper half bridge arm and a lower half bridge arm, a connection point between the upper half bridge arm and the lower half bridge arm is connected to one end of the secondary-side winding of the transformer, a connection point between the two capacitors is connected to the other end of the secondary-side winding of the transformer, the upper half bridge arm and the lower half bridge arm each comprise a group of switching transistors, each group of switching transistors comprises two switching transistors, each of the two switching transistors comprises a freewheeling diode connected in parallel, freewheeling directions of the two freewheeling diodes connected in parallel to each group of switching transistors are opposite, and the switch circuit comprises two groups of controllable switches; and

that the controller is configured to control the switching transistor in the switch circuit to be turned on or off, so that the integration filter circuit restores an output voltage of the sampling circuit comprises:

the controller is configured to:

control, based on statuses of the four switching transistors comprised in the bridge arm and a current direction of the secondary-side winding of the transformer, the two groups of controllable switches to be turned on or off, so that the integration filter circuit restores the output voltage of the sampling circuit.

5. The microinverter according to claim 4, wherein that the controller is configured to control, based on statuses of the four switching transistors comprised in the bridge arm and a current direction of the secondary-side winding of the transformer, the two groups of controllable switches to be turned on or off comprises:

when the two switching transistors comprised in the upper half bridge arm are turned on or the two switching transistors comprised in the lower half bridge arm are turned on, or when only one of the four switching transistors is turned on, the controller is configured to control, based on the current direction of the secondary-side winding of the transformer, one group of controllable switches in the two groups of controllable switches to be turned on and the other group of controllable switches to be turned off.

**6.** The microinverter according to claim 4, wherein that the controller is configured to control, based on statuses of the four switching transistors comprised in the bridge arm and a current direction of the secondary-side winding of the transformer, the two groups of controllable switches to be turned on or off comprises:
when one switching transistor in the upper half bridge arm and one switching transistor in the lower half bridge arm are turned on, when the two switching transistors in the upper half bridge arm and one switching transistor in the lower half bridge arm are turned on, or when one switching transistor in the upper half bridge arm and the two switching transistors in the lower half bridge arm are turned on, the controller is configured to control, based on the current direction of the secondary-side winding of the transformer, the two groups of controllable switches to be alternately turned on or off.

**7.** The microinverter according to claim 6, wherein the upper half bridge arm comprises a switching transistor S8 and a switching transistor S6, the lower half bridge arm comprises a switching transistor S5 and a switching transistor S7, and that the controller is configured to control, based on the current direction of the secondary-side winding of the transformer, the two groups of controllable switches to be alternately turned on or off comprises:

when the switching transistor S6 is turned on, the current direction of the secondary-side winding of the transformer is positive, and the controller controls, based on the positive current direction of the secondary-side winding of the transformer, one group of controllable switches to be turned on; or when the switching transistor S8 is turned on, the current direction of the secondary-side winding of the transformer is negative, and the controller controls, based on the negative current direction of the secondary-side winding of the transformer, one group of controllable switches to be turned on; or
when the switching transistor S5 is turned on, the current direction of the secondary-side winding of the transformer is positive, and the controller controls, based on the positive current direction of the secondary-side winding of the transformer, the other group of controllable switches to be turned on; or when the switching transistor S7 is turned on, the current direction of the secondary-side winding of the transformer is negative, and the controller controls, based on the negative current direction of the secondary-side winding of the transformer, the other group of controllable switches to be turned on.

**8.** The microinverter according to claim 7, wherein one group of controllable switches is connected between one end of the two sampling resistors connected in series and an inverting input end of the integration filter circuit, the one end of the two sampling resistors connected in series is connected to a non-dotted terminal of the secondary-side winding of the transformer, the other group of controllable switches is connected between the other end of the two sampling resistors connected in series and the inverting input end of the integration filter circuit, the one end of the two sampling resistors connected in series is connected to a dotted terminal of the secondary-side winding of the transformer, and the connection midpoint of the two sampling resistors is connected to a non-inverting input end of the integration filter circuit.

**9.** The microinverter according to any one of claims 4 to 8, wherein each group of controllable switches comprises two switching transistors and one freewheeling resistor;

sources of the two switching transistors in each group of controllable switches are connected, drains of two switching transistors in one group of controllable switches are respectively connected to one end of the two sampling resistors connected in series and the inverting input end of the integration filter circuit, drains of two switching transistors in the other group of controllable switches are respectively connected to the other end of the two sampling resistors connected in series and the inverting input end of the integration filter circuit, each of the two switching transistors in each group of controllable switches comprises a freewheeling diode connected in parallel, freewheeling directions of the two freewheeling diodes connected in parallel to each group of controllable switches are opposite, and two ends of the freewheeling resistor are connected in parallel to the drains of the two switching transistors; or
drains of the two switching transistors in each group of controllable switches are connected, sources of two switching transistors in one group of controllable switches are respectively connected to one end of the two sampling resistors connected in series and the inverting input end of the integration filter circuit, sources of two switching transistors in the other group of controllable switches are respectively connected to the other end of the two sampling resistors connected in series and the inverting input end of the integration filter circuit, each of the two switching transistors in each group of controllable switches comprises a freewheeling diode connected in parallel, freewheeling directions of the two freewheeling diodes connected in parallel to each group of controllable switches are opposite, and two ends of the freewheeling resistor are connected in parallel to the sources of the two switching transistors; and

gates of the two switching transistors in each group of controllable switches are connected, and the controller is configured to control a high level or a low level to be input to the gate of the switching transistor, to control the two groups of controllable switches to be turned on or off.

10. The microinverter according to claim 9, wherein the switch circuit further comprises a signal control circuit, the signal control circuit comprises two groups of push-pull circuits, and the two groups of push-pull circuits are correspondingly connected to the two groups of controllable switches respectively;

each group of push-pull circuits comprises two signal switching transistors, two voltage divider resistors, and one capacitor, wherein one of the signal switching transistors is an N-channel switching transistor, the other signal switching transistor is a P-channel switching transistor, a base of the one of the signal switching transistors is connected to the controller, an emitter of the one of the signal switching transistors is grounded, a collector of the one of the signal switching transistors is connected in series to one of the voltage divider resistors and then is connected to a base of the other signal switching transistor, the base of the other signal switching transistor is connected in series to the other voltage divider resistor and then grounded via the capacitor, an emitter of the other signal switching transistor is connected to the other voltage divider resistor and the capacitor, and a collector of the other signal switching transistor is connected to gates of two switching transistors in one group of controllable switches; and

the controller is configured to control a high level or a low level to be input to the base of the signal switching transistor, to control the two groups of controllable switches to be turned on or off.

11. The microinverter according to claim 10, wherein each group of push-pull circuits further comprises other two protection resistors, wherein one of the protection resistors is connected to a base of one of the signal switching transistors, and the other protection resistor is connected to a collector of the other signal switching transistor.

12. The microinverter according to any one of claims 2 to 11, wherein the integration filter circuit comprises an operational amplifier, a filter resistor, and a filter capacitor;

an inverting input end of the operational amplifier is connected to the filter resistor in series, and then is connected to the two ends of the two sampling resistors connected in series;

a non-inverting input end of the operational amplifier is connected to the connection midpoint of the two sampling resistors; and

two ends of the filter capacitor are respectively connected to the inverting input end of the operational amplifier and an output end of the operational amplifier.

13. The microinverter according to claim 12, wherein the integration filter circuit further comprises other two protection resistors, one of the two protection resistors is connected in parallel to the two ends of the filter capacitor, and the other protection resistor is connected to the non-inverting input end of the operational amplifier.

14. The microinverter according to any one of claims 2 to 13, wherein the sampling circuit, the switch circuit, the integration filter circuit, and the controller are integrated in a chip.

15. A current detection method, wherein the method is applied to an inverter, and the method comprises:

controlling four switching transistors in a secondary-side circuit that is in the inverter and that is connected to a secondary-side winding of a transformer to be turned on or off, wherein the secondary-side circuit is configured to convert an alternating current output by the secondary-side winding of the transformer into a power frequency alternating current, and output the power frequency alternating current to a power grid through an output port; and controlling, based on statuses of the four switching transistors and a current direction of the secondary-side winding of the transformer, two groups of controllable switches in a current detection circuit to be turned on or off, so that an integration filter circuit in the current detection circuit restores an output voltage of a sampling circuit in the current detection circuit, wherein the current detection circuit is located between the secondary-side winding of the transformer and the secondary-side circuit, and a current, a voltage, or a frequency of an alternating current obtained through restoration of the integration filter circuit is consistent with that of the alternating current output by the output port.

16. The current detection method according to claim 15, wherein the controlling, based on statuses of the four switching transistors and a current direction of the secondary-side winding of the transformer, two groups of controllable switches to be turned on or off comprises:

when two switching transistors comprised in an upper half bridge arm are turned on or two switching transistors comprised in a lower half bridge arm are turned on, or when only one of the four switching transistors is turned on, controlling, based on the current direction of the secondary-side winding of the transformer, one group of controllable switches in the two groups of controllable switches to be turned on and the other group of controllable switches to be turned off.

17. The current detection method according to claim 16, wherein the controlling, based on statuses of the four switching transistors and a current direction of the secondary-side winding of the transformer, two groups of controllable switches to be turned on or off comprises:

when one switching transistor in the upper half bridge arm and one switching transistor in the lower half bridge arm are turned on, when the two switching transistors in the upper half bridge arm and one switching transistor in the lower half bridge arm are turned on, or when one switching transistor in the upper half bridge arm and the two switching transistors in the lower half bridge arm are turned on, controlling, based on the current direction of the secondary-side winding of the transformer, the two groups of controllable switches to be alternately turned on or off.

18. The current detection method according to claim 17, wherein the upper half bridge arm comprises a switching transistor S8 and a switching transistor S6, the lower half bridge arm comprises a switching transistor S5 and a switching transistor S7, and the controlling, based on the current direction of the secondary-side winding of the transformer, the two groups of controllable switches to be alternately turned on or off comprises:

when the switching transistor S6 is turned on, the current direction of the secondary-side winding of the transformer is positive, and a controller controls, based on the positive current direction of the secondary-side winding of the transformer, one group of controllable switches to be turned on; or when the switching transistor S8 is turned on, the current direction of the secondary-side winding of the transformer is negative, a controller controls, based on the negative current direction of the secondary-side winding of the transformer, one group of controllable switches to be turned on; or

when the switching transistor S5 is turned on, the current direction of the secondary-side winding of the transformer is positive, and a controller controls, based on the positive current direction of the secondary-side winding of the transformer, the other group of controllable switches to be turned on; or when the switching transistor S7 is turned on, the current direction of the secondary-side winding of the transformer is negative, a controller controls, based on the negative current direction of the secondary-side winding of the transformer, the other group of controllable switches to be turned on.

FIG. 1

FIG. 2

Microinverter
system

$V_{ac}$

Current
transformer
peripheral circuit

FIG. 3

410

420

430

$L_s$

$V_{dc}$

Primary-
side
circuit

440

Current
detection
circuit

Secondary-
side circuit

$V_{ac}$

FIG. 4

FIG. 5

FIG. 6

FIG. 7

FIG. 8

FIG. 9

FIG. 10

(a)                    (b)

FIG. 11

FIG. 12

S130

Determine
whether only a switching
transistor in an upper half bridge
arm or only a switching transistor
in a lower half bridge arm
is turned on

Yes

Control a high level to
be input to G1 or G2 — S132

S136

Turn on S8 and/
or S6 in the
upper half
bridge arm, and
input a high
level to G2

S138

Turn on S5 and/
or S7 in the
lower half
bridge arm, and
input a high
level to G1

No

Determine
whether at least one
switching transistor in the upper
half bridge arm and at least one
switching transistor in the
lower half bridge arm
are turned on — S134

Yes

No

S140

Input a low level
to both G1 and
G2

Control a high level to be alternatively input to G1 and G2 — S142

S144

When the switching transistor S6 is turned on, a current
direction of a secondary-side winding of a transformer is
positive, and the high level is input to G2; or when the
switching transistor S8 is turned on, a current direction of a
secondary-side winding of a transformer is negative, and
the high level is input to G2; or when the switching
transistor S5 is turned on, a current direction of a
secondary-side winding of a transformer is positive, and the
high level is input to G1; or when the switching transistor
S7 is turned on, a current direction of a secondary-side
winding of a transformer is negative, and the high level is
input to G1

FIG. 13

FIG. 14

FIG. 15

Control four switching transistors in a secondary-side circuit that is in an inverter and that is connected to a secondary-side winding of a transformer to be turned on or off, where the secondary-side circuit is configured to convert a frequency of an alternating current output by the secondary-side winding of the transformer into a power frequency alternating current, and output the power frequency alternating current to a power grid through an output port

S160

Control, based on statuses of the four switching transistors and a current direction of the secondary-side winding of the transformer, two groups of controllable switches in a current detection circuit to be turned on or off, so that an integration filter circuit in the current detection circuit restores an output voltage of a sampling circuit in the current detection circuit, where the current detection circuit is located between the secondary-side winding of the transformer and the secondary-side circuit, and a current, a voltage, or a frequency of an alternating current obtained through restoration of the integration filter circuit is consistent with that of the alternating current output by the output port

S162

FIG. 16

## INTERNATIONAL SEARCH REPORT

| International application No. |
|---|
| **PCT/CN2024/093546** |

| A. | CLASSIFICATION OF SUBJECT MATTER |
|---|---|

H02M7/5387(2007.01)i; G01R19/25(2006.01)i; G01R15/20(2006.01)i; H02M7/5395(2006.01)i

According to International Patent Classification (IPC) or to both national classification and IPC

| B. | FIELDS SEARCHED |
|---|---|

Minimum documentation searched (classification system followed by classification symbols)

H02M G01R

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 微, 逆变, 电流, 互感, 传感, 高频, 次级, 副边, micro, inverter, current, high 1w frequency, secondary 1w winding

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 117439433 A (HUAWEI DIGITAL POWER TECHNOLOGIES CO., LTD.) 23 January 2024 (2024-01-23) claims 1-18 | 1-18 |
| X | CN 116614017 A (SUNGROW POWER SUPPLY CO., LTD.) 18 August 2023 (2023-08-18) description, paragraphs 49-135, and figures 1-9 | 1-4, 12-15 |
| A | CN 103208939 A (JIANGXI ZHONGNENG ELECTRICAL SCIENCE & TECHNOLOGY CO., LTD.) 17 July 2013 (2013-07-17) entire document | 1-18 |
| A | CN 114884385 A (SHANGHAI JIAO TONG UNIVERSITY) 09 August 2022 (2022-08-09) entire document | 1-18 |
| A | US 2008054719 A1 (NEC MICROWAVE TUBE, LTD.) 06 March 2008 (2008-03-06) entire document | 1-18 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 July 2024** | **17 July 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** |  |
|  | Telephone No. |

Form PCT/ISA/210 (second sheet) (July 2022)

**INTERNATIONAL SEARCH REPORT**
Information on patent family members

International application No.

**PCT/CN2024/093546**

| Patent document cited in search report | | | Publication date (day/month/year) | Patent family member(s) | | | Publication date (day/month/year) |
|---|---|---|---|---|---|---|---|
| CN | 117439433 | A | 23 January 2024 | None | | | |
| CN | 116614017 | A | 18 August 2023 | None | | | |
| CN | 103208939 | A | 17 July 2013 | None | | | |
| CN | 114884385 | A | 09 August 2022 | None | | | |
| US | 2008054719 | A1 | 06 March 2008 | EP | 1895647 | A2 | 05 March 2008 |
| | | | | KR | 20080021537 | A | 07 March 2008 |
| | | | | JP | 2008061332 | A | 13 March 2008 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311235636 X